# FASCICULE DE BREVET EUROPEEN

(11) **EP 3 238 233 B1**
(45) Date de publication et mention de la délivrance du brevet: **17.07.2019**
(21) Numéro de dépôt: 15820159.0
(22) Date de dépôt: 22.12.2015
(51) Int. Cl.: H01L 21/3065, B81C 99/00, G02B 5/18, H01L 21/308, H01L 21/311, H01L 21/768, B29D 11/00, G02B 3/00

(54) **PROCÉDÉ DE RÉALISATION DE MOTIFS**
VERFAHREN ZUR ERZEUGUNG VON MUSTERN
METHOD FOR PRODUCING PATTERNS

(30) Priorité: 22.12.2014 FR 1463153
(43) Date de publication de la demande: 01.11.2017
(73) Titulaire: Commissariat à l'Énergie Atomique et aux Énergies Alternatives, 75015 Paris (FR)
(72) Inventeur: POSSEME, Nicolas, 38360 Sassenage (FR); LANDIS, Stéphan, 38210 Tullins (FR); NOURI, Lamia, 38100 Grenoble (FR)
(74) Mandataire: Hautier, Nicolas
(86) Numéro de dépôt international: PCT/EP2015/081090
(87) Numéro de publication internationale: WO 2016/102628

(56) Documents cités:
- WO-A1-2014/102222
- DE-A1- 2 911 726
- FR-A1- 2 449 971
- US-A- 3 997 367
- US-A1- 2014 342 557
- US-B1- 6 207 517

## Description

### DOMAINE TECHNIQUE DE L'INVENTION

L'invention concerne en général la réalisation de structures dans le domaine des procédés utilisés par l'industrie de la micro-électronique pour la fabrication de toutes sortes de systèmes, de taille micrométrique et nanométrique, combinant possiblement des composants électroniques, optiques et mécaniques.

Plus précisément, elle concerne les procédés dans lesquels il est nécessaire d'aligner des motifs par rapport à d'autres motifs préalablement réalisés.

L'invention trouve pour application particulièrement avantageuse la réalisation de microlentilles asphériques destinées à des applications de collection de lumière, d'imagerie et de guidage de la lumière. Elle trouve également comme application avantageuse la réalisation de structures dites « double damascène » pour l'interconnexion verticale de lignes métalliques notamment en cuivre.

### ÉTAT DE LA TECHNIQUE

Pour de nombreuses applications, il est nécessaire de réaliser des motifs alignés sur d'autres motifs préalablement définis lors d'opérations de photolithographie et de gravure précédentes.

La réduction constante des dimensions des motifs pose alors la difficulté de parvenir à effectivement aligner les motifs avec suffisamment de précision lors d'opérations successives de photolithographie.

Ce problème est particulièrement important pour la réalisation de matrices de microlentilles utilisées dans de nombreux dispositifs optoélectroniques. Dans ce domaine il existe déjà de nombreux procédés de fabrication. Une revue de techniques connues de fabrication de microlentilles pourra par exemple être trouvée dans la publication suivante en langue anglaise : « Journal of Optics A: Pure and Applied Optics 8, issue 7 » pages 407-429, publiée en 2006.

Parmi celles-ci, l'impression microjet ou « microjet printing » et le fluage thermique ou « thermal reflow » sont désormais des techniques très avancées qui sont utilisées dans l'industrie pour réaliser des microlentilles de haute qualité optique. Cependant, ces techniques sont plus qualitatives que quantitatives lorsqu'il s'agit d'atteindre un profil de surface prédéterminé destiné à conférer aux lentilles les propriétés optiques attendues. Par exemple, le fluage thermique de photo-résine et l'impression microjet sont basés sur les tensions de surfaces ce qui limite fortement le choix des profils de surface que l'on peut obtenir en pratique avec ces techniques.

D'autres techniques connues telles que l'ablation laser, la polymérisation à deux photons et l'écriture directe au laser permettent d'obtenir un très grand choix de profil de surfaces, mais sont des techniques séquentielles qui demandent que chaque lentille d'une matrice soit individuellement façonnée. Il en résulte que ces techniques ne sont pas applicables en termes de coût et de rendement à une échelle industrielle.

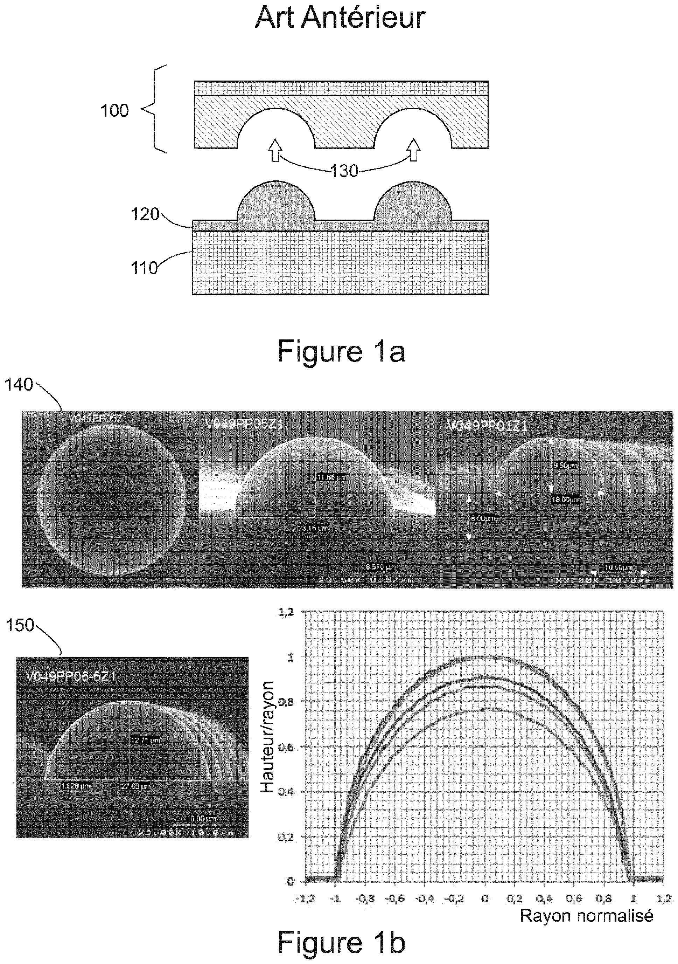

Plus récemment, les techniques de moulage et d'impression telles que celles généralement désignées par leurs appellations anglaises de « hot embossing », « imprinting » et « injection moulding » ont beaucoup été utilisées pour réaliser des microlentilles. Le principe de fabrication, illustré par la **figure 1****,** composée des figures 1a et 1b, est de remplir un moule 100 d'un matériau malléable, typiquement un polymère, et d'ensuite détacher 130 celui-ci du matériau moulé 120. La figure 1b montre que les microlentilles obtenues de cette façon peuvent être de formes hémisphérique 140 et asphérique 150. Selon le type de substrat 110 sur lequel le moulage est fait, en silicium ou en quartz, les applications pourront concerner, respectivement, le domaine des longueurs d'ondes de l'infra-rouge (IR) ou celui de la lumière visible.

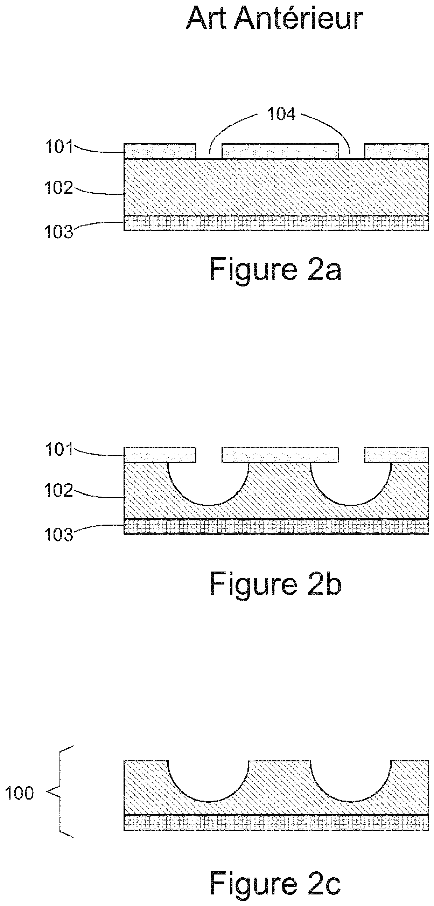

Les méthodes de fabrication par impression nécessitent de disposer de moules qui peuvent être eux-mêmes fabriqués par exemple à l'aide des techniques citées dans la publication mentionnée ci-dessus (« Journal of Optics »). En règle générale, les techniques standard mises en oeuvre par l'industrie de la microélectronique sont le plus souvent préférées car elles sont très fiables et l'intégration des microlentilles aux composants finaux, typiquement des composants électronique de type transistor, en est facilitée. La **figure 2****,** composée des figures 2a à 2c, illustre un exemple de fabrication de moule. Comme montré sur la figure 2a, après dépôt d'une couche 102 d'un oxyde thermique de silicium (SiO2) ou silice, par exemple d'une épaisseur de 20 micromètres (µm), sur un « wafer » du type de ceux utilisés couramment par l'industrie de la microélectronique, c'est-à-dire une tranche 103 de silicium de grand diamètre, par exemple d'un diamètre de 8 pouces, une couche 101 de nitrure de silicium (Si3N4), par exemple d'une épaisseur de 350 nanomètres, est déposée sur la couche d'oxyde thermique. Les motifs 104 destinés à former les reliefs du moule sont d'abord gravés dans la couche de nitrure 101 à l'aide d'étapes conventionnelles de lithographie (figure 2a). Le wafer est alors immergé dans une solution de gravure humide, par exemple une solution à base d'acide fluorhydrique (HF). Comme montré sur la figure 2b le masque de nitrure protège les zones du wafer où la solution de gravure ne doit pas attaquer la couche de silice 102. La gravure de la couche de silice 102 est isotrope, formant ainsi une cavité en forme de portion de sphère centrée sur les motifs 104. A l'étape suivante illustrée en figure 2c le masque de nitrure est retiré et après application d'un traitement antiadhésif, le wafer peut être utilisé comme moule 100 pour l'impression.

Optionnellement, les motifs en relief du moule peuvent être créés directement dans le silicium 103 sans avoir recours à la couche intermédiaire de silice 102. Dans ce cas, la solution de gravure est un mélange d'acide fluorhydrique (HF) et d'acide nitrique (HNO3) comme rapporté en 2009 dans un article paru dans la revue en langue anglaise Optics Express, Volume 17, Edition 8, pages 6283 à 6292 (2009).

Si les procédés de fabrication de moule brièvement décrits ci-dessus conviennent bien pour l'obtention, comme représenté, de motifs sphériques ou hémisphériques il est en revanche difficile d'obtenir des lentilles dites asphériques de formes voulues avec ces procédés. Or la production de matrices de micro lentilles asphériques est généralement requise dans beaucoup d'applications. Ces lentilles asphériques présentent en effet habituellement des propriétés optiques bien meilleures. Notamment, les lentilles sphériques, contrairement aux lentilles asphériques, induisent des aberrations optiques, les rayons passant par le centre de la lentille ne convergeant pas exactement au même point que ceux passant par les bords. Ceci provoque un flou aux grandes ouvertures et un élargissement de la tache de focalisation qu'il n'est pas possible d'ignorer dans la plupart des applications.

Il faut alors avoir recours à l'utilisation de lasers et aux techniques dites de « laser machining » ou ablation laser, déjà mentionnées ci-dessus, qui seules sont susceptibles de pouvoir créer les profils complexes nécessaires avec toutefois l'inconvénient majeur que chaque micro lentille doit alors être façonnée individuellement. Ces techniques sont par exemple décrites dans l'article Spherical and Aspheric Microlenses Fabricated by Excimer Laser LIGA-like Process Yung-Chun Lee, Chun-Ming Chen and Chun-Ying Wu paru en 2006 dans la revue en langue anglaise « Journal of Manufacturing Science and Engineering » 129, 126-134.

De manière générale, il n'existe pas de procédé simple, rapide, c'est-à-dire opérable en une seule série d'étapes à l'échelle d'un wafer, également compatible avec les techniques standard de la microélectronique et qui permette de contrôler simplement le profil de surface en vue de produire notamment des matrices de lentilles asphériques.

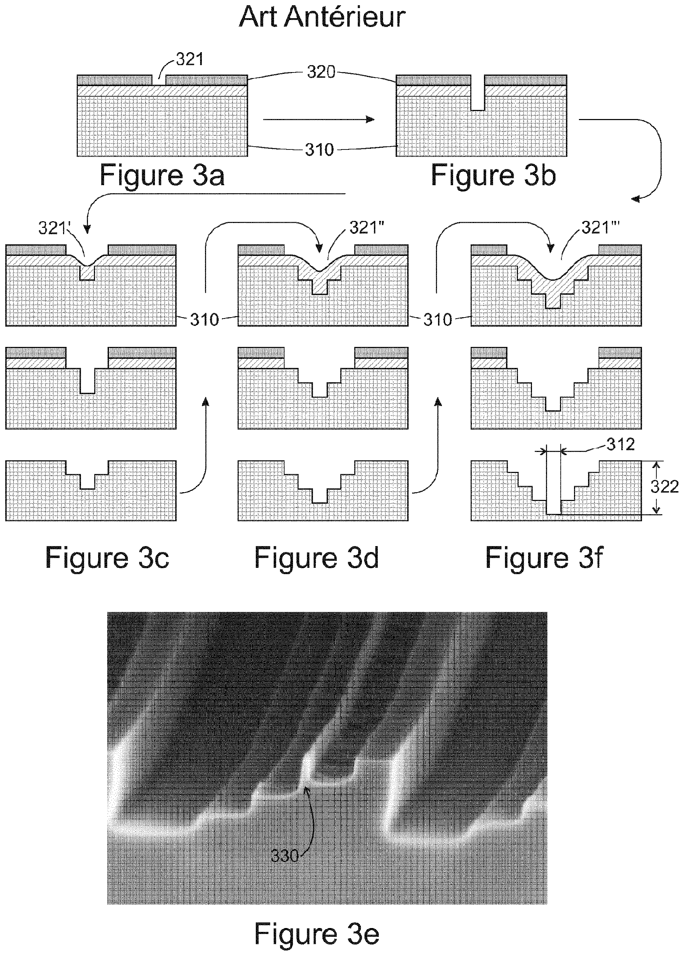

Une autre façon d'aborder le problème de la création de profils complexes, comme ceux nécessaires à la production des lentilles asphériques et aussi pour des applications autres que l'optique, consiste à pouvoir réaliser des structures tridimensionnelles (3D) en marches d'escalier c'est-à-dire présentant plusieurs niveaux discrets de hauteurs comme illustré sur la **figure 3****,** composée des figures 3a à 3e. Dans le cas de la production de matrices de micro lentilles on va alors pouvoir approximer les profils souhaités à l'aide d'un plus ou moins grand nombre de marches.

Le procédé standard qui permet la réalisation de ces structures 3D en marches d'escalier est compliqué et nécessite un nombre conséquent d'étapes comme cela est illustré sur la figure 3. Il faut pouvoir répéter en fonction du nombre de marches à réaliser, au nombre de 4 dans l'exemple de la figure 3, une série d'étapes de lithographie et gravure, représentées par les figures 3a à 3f, qui peuvent être difficiles à mettre en oeuvre pour des dimensions critiques 312 de motifs à réaliser, typiquement inférieures au µm, et pour des rapports de formes élevés 322, typiquement supérieurs à 3.

Une difficulté particulière consiste à pouvoir aligner précisément les étapes successives de structuration les unes par rapport aux autres. En particulier, après chaque gravure du substrat 310, il faut redéposer une couche de résine 320 et reformer un motif aligné sur le motif précédent. Ainsi, les motifs 321', 321", 321'" doivent tous être alignés sur le motif 321.

A défaut de pouvoir aligner très précisément les opérations de photolithographies correspondantes entre elles on peut obtenir des artefacts de gravure 330 comme celui apparaissant sur la figure 3e qui est une photographie réalisée à partir d'un équipement de microscopie électronique à balayage sur une structure 3D à quatre niveaux similaire à celles des figures précédentes. La présence de tels défauts est évidemment très dommageable et ne permet plus d'obtenir le profil final souhaité.

Un objet de la présente invention est donc de proposer un procédé s'appliquant au niveau d'un wafer pour la production de profils et qui permette de s'affranchir ou au moins de limiter certains au moins des problèmes exposés ci-dessus.

Notamment, la présente invention a pour objectif de proposer une solution simple et fiable pour obtenir un profil à partir d'opérations de lithographies qui nécessitent d'être auto-alignées et ceci tout en offrant un bon contrôle dimensionnel.

Le document US 6,207,517 décrit un procédé de fabrication de dispositifs semi-conducteurs pour réaliser des transistors. Le procédé comprend la réalisation d'un premier masque présentant une ouverture et recouvrant un substrat à graver. Une première implantation est réalisée à travers ce premier masque pour implanter le substrat à graver. Le premier masque est ensuite retiré puis un deuxième masque est réalisé sur le substrat. Ce deuxième masque présente une ouverture qui est plus large que l'ouverture du premier masque et que l'on cherche à centrer sur la zone implantée à travers l'ouverture du premier masque. Une deuxième implantation est réalisée à travers ce deuxième masque pour implanter le substrat à graver sur une profondeur inférieure à la profondeur de la première implantation. Le deuxième masque est ensuite retiré. Les zones implantées du substrat sont gravées sélectivement aux zones non implantées.

Ce procédé nécessite de nombreuses étapes. Par ailleurs, certaines étapes sont délicates et peu précises. Tel est le cas de l'étape consistant à centrer l'ouverture du deuxième masque sur la zone implantée à travers l'ouverture du premier masque.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de réalisation de motifs dans une couche à graver, à partir d'un empilement comprenant au moins la couche à graver et une couche de masquage surmontant la couche à graver, la couche de masquage présentant au moins un motif, le procédé comprenant au moins:
a) une étape de modification d'au moins une zone de la couche à graver par implantation d'ions au droit de l'au moins un motif ;
b) au moins une séquence d'étapes comprenant :
   b1) une étape d'élargissement de l'au moins un motif selon un plan dans lequel s'étend principalement la couche à graver ;
   b2) une étape de modification d'au moins une zone de la couche à graver par implantation d'ions au droit de l'au moins un motif élargi, l'implantation étant effectuée sur une profondeur inférieure à la profondeur d'implantation de l'étape immédiatement précédente de modification ;
c) une étape de retrait des zones modifiées, le retrait comprenant une étape de gravure humide des zones modifiées sélectivement aux zones non modifiées de la couche à graver.

Par ailleurs:
- soit la couche de masquage est un masque dur,
- soit la couche de masquage comprend du carbone et l'empilement comprend une couche tampon disposée entre la couche de masquage comprenant du carbone et la couche à graver, la couche tampon recouvrant la couche à graver lors de l'implantation.

Ainsi, l'invention permet, grâce notamment à l'étape d'élargissement du motif initial présent dans une couche de masquage qui est conservée et à l'étape d'implantation, de définir plusieurs zones modifiées qui sont automatiquement alignées les unes par rapport aux autres.

En effet, la couche de masquage est conservée au-dessus de la couche à graver sans être entièrement retirée entre deux implantations. Ladite couche de masquage est conservée après l'étape de modification afin effectuer l'étape d'élargissement. Les motifs successifs servant aux implantations successives sont donc formés dans la couche de masquage initiale et par des élargissements successifs d'un motif initial présent dans cette couche de masquage initiale. Par conséquent tous ces motifs sont auto-alignés.

Par ailleurs, le procédé selon l'invention évite que des atomes de carbone présents dans la couche de masquage soient arrachés à la surface de cette dernière lors de l'implantation et pénètrent dans la couche à graver. Cela aurait pour effet de modifier la surface de la couche à graver, ce qui empêcherait la gravure humide de cette dernière lors de l'étape de retrait. La couche à graver serait donc non gravée ou bien les motifs ne seraient pas transférés avec précision dans la couche à graver. Pour cela le procédé selon l'invention prévoit que la couche de masquage soit un masque dur ou que l'empilement comprenne une couche tampon recouvrant la couche à graver lors de l'implantation.

Par ailleurs, ce procédé est rapide et parfaitement conforme aux contraintes industrielles en termes de productivité. En particulier la gravure humide offre un gain de temps tout en apportant un bon contrôle dimensionnel et un bon état de surface.

L'invention permet ainsi d'obtenir une structure dont le profil est exempt des défauts d'alignement habituellement rencontrés avec les procédés connus nécessitant des opérations successives de lithographies.

L'invention offre ainsi une solution simple et fiable pour obtenir un profil possiblement complexe et présentant une définition améliorée, optionnellement en répétant ladite séquence d'étapes b1) et b2) avant l'étape c).

Un autre objet de la présente invention concerne un procédé de réalisation de moule pour former par nano-impression des lentilles asphériques. Le procédé comprend les étapes a) à c) conformément à l'invention dans lequel la séquence d'étapes b1) et b2) est répétée de manière à obtenir un profil en creux, asphérique, formé de marche d'escaliers.

Un autre objet de la présente invention concerne un procédé de réalisation d'une structure de type double damascène. L'empilement comprend une couche sous-jacente à la couche à graver. Le procédé comprend les étapes a) à c) ci-dessus. Les motifs initiaux de la couche de masquage présentent un profil semblable à des via d'interconnexion. L'étape d'élargissement b1) est réalisée de manière à rendre au moins certains des motifs initiaux jointifs. L'étape b2) est réalisée de manière à ce que la zone implantée présente un profil semblable à une ligne d'interconnexion. Le profil obtenu à l'issue de l'étape c) est ensuite transféré dans la couche sous-jacente.

L'invention permet de fabriquer un dispositif électronique. Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1, composée des figures 1a et 1b, illustre le principe de fabrication par moulage de lentilles hémisphériques ou formées par une portion de sphère.
La FIGURE 2, composée des figures 2a à 2c, illustre un exemple de fabrication de moule d'impression portant une empreinte qui forme une portion de sphère.
La FIGURE 3, composée des figures 3a à 3e, illustre une méthode conventionnelle de réalisation d'une structure tridimensionnelle (3D) en marches d'escalier.
La FIGURE 4, composée des figures 4a à 4i, décrit les étapes d'un exemple de procédé selon l'invention qui permet par exemple de réaliser des structures 3D en marches d'escalier auto alignées.
La FIGURE 5 compare l'utilisation d'un implanteur classique et celle d'un réacteur de gravure pour les opérations d'implantation d'ions mises en oeuvre dans le cadre de l'invention.
La FIGURE 6, composée des figures 6a et 6b, illustre l'utilisation d'un implanteur classique avec l'emploi d'une couche tampon entre la résine et le substrat à implanter.
La FIGURE 7 présente des exemples de conditions d'implantation dans du Si ou du SiN.
La FIGURE 8, composée des figures 8a à 8d, montre comment déterminer le nombre d'étapes de trimming de la résine nécessaires pour réaliser un profil donné.
La FIGURE 9, composée des figures 9a à 9d, illustre une autre application de l'invention qui est utilisée dans cet exemple pour réaliser une structure dite « double damascène » auto alignée.
La FIGURE 10 illustre la structure du SiOCH après l'implantation d'H et d'Ar.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :
Selon un mode de réalisation, l'étape d'élargissement de l'au moins un motif comprend une gravure anisotrope la couche de masquage dont la direction principale est parallèle à un plan dans lequel s'étend principalement la couche à graver. Cette gravure grave la couche de masquage sélectivement à la couche à graver.

L'étape d'élargissement de l'au moins un motif de la couche de masquage ne grave pas la couche à graver.

Selon un mode de réalisation, l'empilement comprend une couche tampon disposée entre la couche de masquage et la couche à graver.

Selon un mode de réalisation, la couche tampon recouvre la couche à graver lors de l'implantation.

Ainsi la couche tampon demeure au-dessus de la couche à graver lors de l'étape de modification par implantation. Ainsi les éléments de la couche de masquage qui pourraient avoir tendance à se déplacer en direction de la couche à graver sous l'effet de l'implantation se trouvent stoppés ou piégés dans la couche tampon. Ces éléments, typiquement du carbone de la couche de masquage en résine, ne parviennent ainsi pas dans la couche à graver. Lors de la gravure des zones modifiées de la couche à graver, ces éléments ne perturberont pas la gravure, permettant ainsi d'obtenir un très bon contrôle dimensionnel des motifs gravés dans la couche à graver. Sans la couche tampon, des atomes de carbone présents dans la couche de masquage auraient été arrachés à la surface de cette dernière lors de l'implantation et auraient pénétré dans la couche à graver ce qui aurait empêché la gravure cette dernière lors de l'étape de retrait. La couche de silicium aurait donc été non gravée ou bien les motifs n'auraient pas été transférés avec précision dans la couche à graver.

Selon un mode de réalisation, la couche de masquage comprend du carbone. Il s'agit par exemple d'une résine. L'épaisseur de la couche tampon, après l'étape d'élargissement et avant l'implantation, est suffisante pour former une barrière empêchant, lors de ladite implantation, à du carbone provenant de la couche de masquage de pénétrer à l'intérieur de la couche à graver.

Selon un mode de réalisation, l'épaisseur de la couche tampon, après l'étape d'élargissement et avant l'implantation, est d'au moins 10nm et de préférence d'au moins 20nm et de préférence d'au moins 30 nm.

Selon un mode de réalisation avantageux, l'implantation est effectuée pleine plaque c'est-à-dire sur toute la surface de l'empilement.

Selon un autre mode de réalisation, la couche tampon (610) est en un matériau pris parmi les matériaux suivants : SixOy, SiOx, SixNy, SiNx, TiN, SiARC.

De préférence la couche tampon est en un matériau pris parmi les matériaux suivants : SiO2, SiN, TiN, le SiARC.

Selon un autre mode de réalisation, le matériau de la couche de masquage et le matériau de la couche tampon sont différents. L'étape d'élargissement de l'au moins un motif de la couche de masquage comprend une gravure de la couche de masquage sélectivement à la couche tampon, la gravure étant de préférence une gravure anisotrope dont la direction principale est parallèle à un plan dans lequel s'étend principalement la couche à graver.

Selon un autre mode de réalisation, la couche de masquage et la couche tampon sont en résine.

Selon un autre mode de réalisation, la couche tampon forme un résidu de résine dans un fond du motif de la couche de masquage. Avantageusement, la couche tampon et l'étape d'élargissement de l'au moins un motif sont choisies de manière à conserver une partie au moins de la couche tampon pour qu'elle recouvre entièrement la couche à graver à l'issue de ladite au moins une séquence et avant ladite étape de retrait des zones modifiées.

Selon un mode de réalisation la couche de masquage est disposée directement au contact de la couche à graver.

Selon un mode de réalisation la couche de masquage est une couche carbonée.

L'implantation est effectuée avec un implanteur. De préférence, l'épaisseur de la couche tampon est réglée de manière à ce qu'au niveau des zones modifiées les ions soient implantés en continu depuis la surface de la couche à graver.

Selon un autre mode de réalisation, la couche de masquage est directement au contact de la couche à graver.

Selon un mode de réalisation avantageux, l'implantation est effectuée dans un réacteur plasma. Cela présente pour avantage de pouvoir implanter les ions en continu depuis la surface de la couche à graver.

Selon un mode de réalisation, préalablement à ladite séquence d'étapes, on effectue une étape de réalisation dans la couche de masquage de l'au moins un motif. L'étape de réalisation dans la couche de masquage de l'au moins un motif comprend au moins une étape de lithographie et une étape de gravure de la couche de masquage.

Selon un mode de réalisation, l'étape de gravure utilise une solution d'hydroxyde d'ammonium tétra-méthyle (TMAH) ou d'acide fluorhydrique (HF), de préférence sous atmosphère d'oxygène. Cette gravure permet une très bonne sélectivité des zones modifiées par implantation par rapport aux zones non modifiées. Ainsi, le silicium cristallin de la couche à graver n'est pas ou peu consommé par ce type de nettoyage alors que le silicium rendu amorphe par l'implantation est aisément consommé.

Selon un mode de réalisation avantageux, préalablement aux étapes a) à c) le motif forme une ouverture dans toute l'épaisseur de la couche de masquage. Ainsi, la couche de masquage forme un masque portant au moins un motif.

Selon un mode de réalisation la couche à graver est mise à nu au droit de l'au moins un motif préalablement à l'implantation d'ions. Ainsi, l'implantation de la couche à graver est effectuée sur la couche à graver mise à nu.

Selon un autre mode de réalisation, la couche à graver n'est pas mise à nu lors de son implantation. Ainsi, l'implantation dans la couche à graver est effectuée à travers une épaisseur résiduelle surmontant la couche à graver. Cette couche résiduelle également surmontant la couche à graver est de préférence la couche de masquage en résine. Cette couche résiduelle joue alors le même rôle que la couche tampon mentionnée ci-dessus. Ainsi, ce mode de réalisation avec épaisseur résiduelle est avantageux notamment lorsque l'implantation s'effectue à l'aide implanteur classique à faisceau. En effet avec un tel implanteur il est difficile d'implanter en surface. Prévoir une couche résiduelle, par exemple de résine permet d'éviter ce problème et d'implanter sur toute l'épaisseur souhaitée depuis la surface de la couche à graver en adaptant les conditions d'implantation et l'épaisseur de la couche résiduelle.

Ainsi, les conditions d'implantation et l'épaisseur de la couche résiduelle sont réglées de manière à ce qu'au niveau des zones modifiées les ions soient implantés en continu depuis la surface de la couche à graver.

Selon un mode de réalisation la couche de masquage est une couche de résine. La résine est faite d'un matériau organique ou organo-minéral pouvant être mis en forme par une exposition à un faisceau d'électrons, de photons ou de rayons X ou mécaniquement. L'intérêt d'utiliser une résine est qu'il est facile d'en déposer une épaisseur importante, de plusieurs centaines de nanomètres à plusieurs microns. On n'est donc pas gêné par la consommation verticale lors de l'étape de trimming. De préférence on utilise également une couche tampon non carbonée avec la couche de résine. Cette couche tampon peut alors par exemple être en SiOx ou en SiNx et plus particulièrement en SiO2 ou SiN.

Selon un mode de réalisation la couche tampon est une couche carbonée, typiquement une couche de résine. Il peut s'agir d'une épaisseur résiduelle de la couche de masquage.

Selon un autre mode de réalisation la couche de masquage est une couche formant un masque dur.

Le masque dur est par exemple un masque dur inorganique, non carboné. Il peut alors être par exemple en SiOx ou en SiNx et plus particulièrement en SiO2 ou SiN. Il peut également être un masque dur métallique, par exemple en TiN.

Selon un mode de réalisation la couche de masquage est disposée directement au contact de la couche à graver. L'étape d'élargissement de l'au moins un motif de la couche de masquage comprend une gravure de la couche de masquage sélectivement à la couche à graver, la gravure étant une gravure anisotrope dont la direction principale est de préférence parallèle à un plan dans lequel s'étend principalement la couche à graver.

Selon un mode de réalisation, lequel le matériau du masque dur est pris parmi le SiOx, le SiNy, le SiARC et le TiN.

Préalablement à l'implantation d'ions la couche à graver est mise à nu au droit de l'au moins un motif élargi.

Avantageusement, on utilisera un masque dur pour réaliser des motifs de petites dimensions latérales nécessitant donc une faible ouverture totale dans le masque et donc une faible épaisseur de masque.

Selon une variante avantageuse, on dispose sur la couche de masquage au moins une couche de protection, le matériau de la couche de protection étant choisi de manière à empêcher ou à réduire une consommation verticale du masque dur lors de l'étape d'élargissement du motif formé dans la masque dur. Dans ce mode de réalisation, le matériau du masque dur est de préférence pris parmi le SiOx et le SiNy et dans lequel le matériau de la couche de protection est l'autre parmi le SiOx et le SiNy.

Selon un mode de réalisation l'épaisseur de la couche tampon est réglée de manière à ce qu'au niveau des zones modifiées les ions soient implantés en continu depuis la surface de la couche à graver.

Selon un mode de réalisation l'implantation est effectuée dans un réacteur plasma.

Selon un mode de réalisation avantageux, on effectue, avant l'étape c) de retrait des zones modifiées, plusieurs fois, de préférence au moins trois fois, ladite séquence d'étapes b1) et b2). Ainsi, au cours des étapes successives d'agrandissement et d'implantation du motif agrandi on ajuste à chaque étape la valeur de trimming de la couche de masquage et la profondeur de modification de la couche à graver afin d'obtenir le profil souhaité.

Selon un mode de réalisation avantageux, les étapes b) et c) sont choisies, en particulier l'élargissement de l'au moins un motif et la profondeur d'implantation, de manière à ce que les zones modifiées forment un profil en marches d'escalier.

Selon un mode de réalisation avantageux, après gravure dans la couche à graver d'un profil en marches d'escalier on procède à un lissage dudit profil par oxydation et désoxydation du matériau du substrat.

Selon un mode de réalisation avantageux, le profil présente le négatif d'une forme de lentille asphérique. Alternativement le profil présente une forme de lentille sphérique.

Selon un mode de réalisation avantageux, le profil forme un moule configuré pour pénétrer dans une résine imprimable afin d'y transférer par nano-impression le profil.

Selon un mode de réalisation avantageux, préalablement aux étapes a) à c), la couche de masquage comporte une pluralité de motifs et les étapes a) à c) sont appliquées à ladite pluralité de motifs.

Selon un mode de réalisation avantageux, préalablement aux étapes a) à c), la couche de masquage comporte une pluralité de motifs formant des ouvertures dans l'épaisseur de la couche de masquage, de préférence traversant la couche de masquage et l'étape d'élargissement est effectuée de manière à supprimer la matériau de la couche de masquage, typiquement la résine, séparant au moins deux motifs, de manière à rendre ces au moins deux motifs jointifs après élargissement.

Selon un mode de réalisation avantageux, préalablement aux étapes a) à c), la couche de masquage comporte une pluralité de motifs destinés à former des vias d'interconnexion, l'étape d'élargissement étant effectuée de manière à joindre au moins certains des vias d'interconnexion. Le profil réalisé dans la couche à graver présente une forme de structure double damascène.

Selon un mode de réalisation avantageux, le profil formé dans la couche à graver est ensuite transféré dans une couche sous-jacente recouverte par la couche à graver, la couche à graver faisant office de masque dur lors du transfert du profil dans la couche sous-jacente.

De préférence, le procédé comprend une étape de remplissage du profil obtenu par un métal.

Avantageusement, le profil obtenu en fin de procédé est une structure double damascène.

Selon un mode de réalisation avantageux, la couche à graver est une couche ou un substrat dont le matériau est pris parmi : le silicium, le silicium germanium, le germanium, le nitrure de silicium, le saphir, le quartz ce dernier étant cristallin au contraire du verre.

Selon un autre mode de réalisation, la couche à graver est une couche ou un substrat en SiOCH. Le SiOCH peut être poreux ou dense. Ce matériau présente pour avantage d'avoir une très faible permittivité, en particulier lorsqu'il est poreux.

Selon un mode de réalisation avantageux, la couche à graver en SiOCH est surmontée d'une couche protectrice située entre la couche de masquage et la couche à graver.

Selon un mode de réalisation avantageux, lors de l'implantation la couche protectrice est, au droit du motif, recouverte d'un résidu de couche de masquage formant une couche tampon dont l'épaisseur est plus faible que l'épaisseur de la couche de masquage en dehors du motif

Selon un mode de réalisation avantageux, la couche à graver est une couche cristalline.

On pourra notamment utiliser les espèces ci-dessous : l'hydrogène (H2), l'hélium (He), l'argon (Ar) ou l'azote (N2).

Dans le cadre de la présente invention on pourra utiliser les méthodes connues de l'homme du métier et logiciels (SRIM, TRIM, CTRIM...) qui permettent de simuler en fonction des conditions d'implantations (espèces implantées, matériau implanté, dose, énergie, temps d'exposition de la couche implantée au faisceau d'ions...) l'implantation résultante et notamment la profondeur d'implantation.

Avantageusement, les paramètres d'implantation, en particulier l'énergie communiquée aux ions, la durée et la dose d'implantation sont prévus de sorte que les zones implantées puissent être gravées sélectivement par rapport aux zones non-implantées. De préférence, ces paramètres d'implantation permettent de faire passer la matière depuis un état cristallin à un état amorphe.

De préférence, l'implantation d'espèces concerne tous les éléments que l'on peut implanter dans le matériau à graver, sans provoquer de dislocation de sa structure atomique telle qu'elle entraînerait une pulvérisation de la matière implantée, sont susceptibles de convenir.

Par exemple, les ions implantés sont pris parmi l'hydrogène (H2), l'hélium (He), l'argon (Ar) ou l'azote (N2). Une seule ou plusieurs de ces espèces peuvent être implantées.

Selon un mode de réalisation, l'implantation est réalisée de manière anisotrope, selon au moins une direction d'implantation sensiblement perpendiculaire au plan dans lequel s'étend la couche à graver ou un substrat sur lequel est disposée la couche à graver. Sur les figures, la direction privilégiée d'implantation est la direction Z.

Il est précisé que dans le cadre de la présente invention, le terme « sur », « surmonte », « recouvre » ou « sous-jacent » ou leurs équivalents ne signifient pas « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

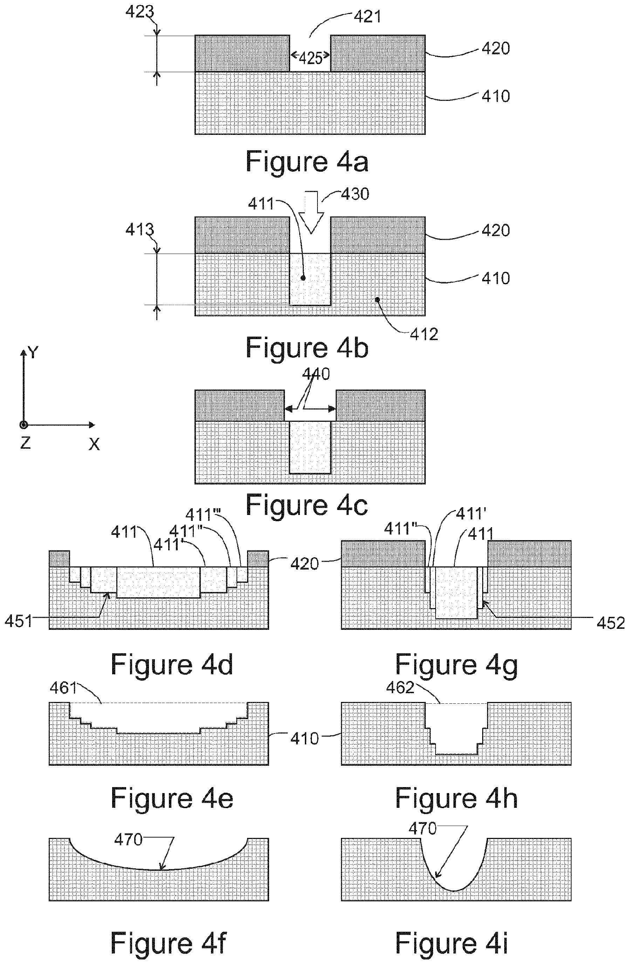

Dans le cadre de la présente invention, l'épaisseur d'une couche est prise selon une direction perpendiculaire aux faces principales du substrat sur lequel repose les différentes couches. Sur les figures, l'épaisseur est prise selon la direction Z indiquée sur le repère illustré en figure 4c. Sur les figures, la largeur d'un motif est prise selon la direction X indiquée sur ce même repère. L'épaisseur est ainsi prise selon une direction contenue dans le plan principal dans lequel s'étend la couche.

De même lorsqu'on indique qu'une zone est située au droit d'un motif, cela signifie que ce motif et cette zone sont situés tous deux sur une même ligne perpendiculaire au plan principal du substrat, soit sur une même ligne orientée verticalement sur les figures.

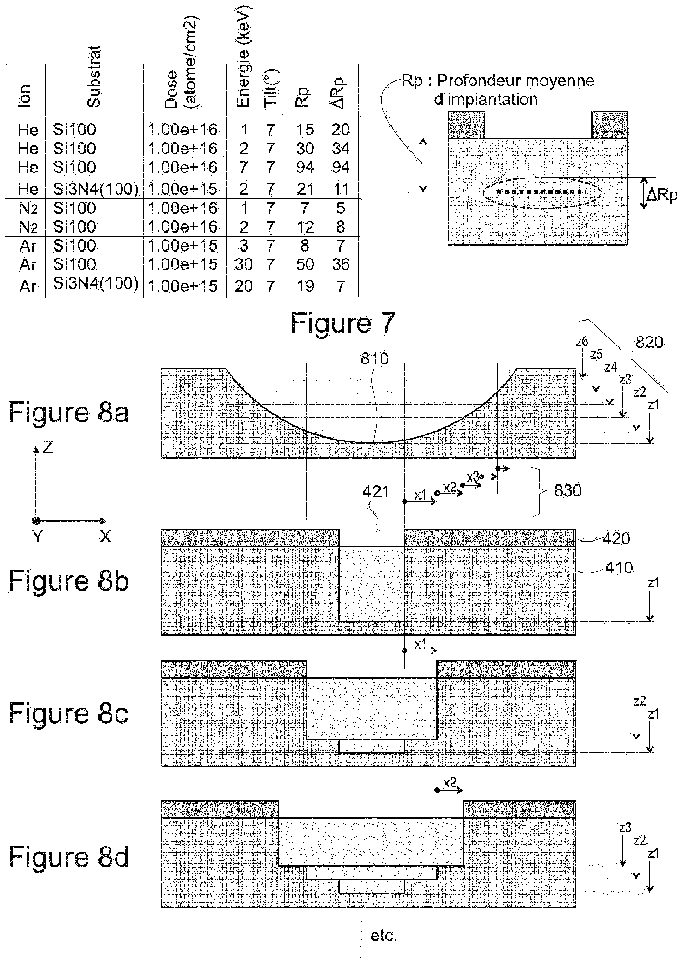

Dans le cadre de la présente invention, on désigne par motif en trois dimensions (3D) un motif présentant dans une couche donnée, par exemple une résine ou un substrat, un profil analogique avec une variation continue des tangentes de la forme du profil comme dans les figures 4e, 4h ou 8 par exemple ou présentant au moins deux niveaux de profondeur au-dessous de la face supérieure de la couche lorsque le motif est en creux ou au moins deux niveaux de hauteur au-dessus d'une face supérieure de la couche lorsque le motif est en saillie. Un motif dit 2D désigne le cas particulier d'un motif n'ayant que deux niveaux de hauteur ou de profondeur.

La **figure 4****,** composée des figures 4a à 4i, décrit les étapes du procédé de l'invention qui permet de s'affranchir des problèmes décrits précédemment dans l'état de la technique pour réaliser notamment des structures 3D, par exemple des profils en marches d'escalier.

Le procédé de l'invention permet en effet de réaliser, au moyen d'une succession d'étapes d'implantation d'ions, des moules de formes courbes contrôlées afin d'obtenir notamment des microlentilles asphériques. De manière particulièrement avantageuse, cela se fait à partir d'une seule opération de photolithographie et en procédant avant chaque implantation à une consommation horizontale de la couche de résine protégeant les zones non implantées de façon à étendre, à l'issue de chacune de ces étapes, les zones implantées. Les implantations se font possiblement avec des conditions différentes, notamment des profondeurs différentes.

Les opérations de de gravure horizontale ou de consommation horizontale de la couche de masquage, par exemple en résine, sont qualifiées dans ce qui suit du terme anglais de « trimming » largement utilisé par l'industrie de la microélectronique pour désigner ce type d'ajustement des dimensions horizontales d'un motif.

Un contrôle précis des conditions d'implantation en fonction des conditions de trimming de la couche de masquage permet alors d'obtenir les formes de lentille optimales pour une application donnée à l'aide d'un procédé peu coûteux. Un avantage majeur du procédé de l'invention est en effet qu'il permet de réaliser des structures auto-alignées à partir d'une seule étape initiale de photolithographie et donc à moindre coût par comparaison à la succession d'étapes de photolithographie indépendantes du procédé conventionnel où l'on doit réaligner les surfaces implantées les unes par rapport aux autres à chaque étape et avec les inconvénients discutés précédemment dans la description de la figure 3.

Comme montré sur la figure 4a on part de préférence d'un empilement comprenant au moins une couche à graver 410 et une couche de masquage 420 surmontant la couche à graver.

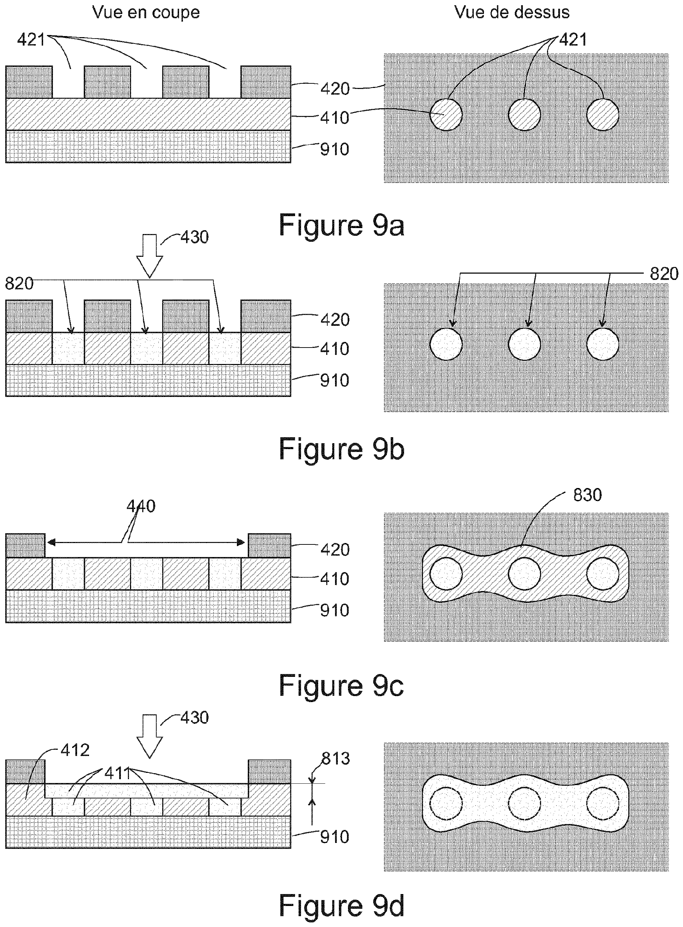

Dans la suite de la description, par souci de concision et de clarté, on désigne par « substrat 410 » cette couche à graver dans laquelle des motifs vont être formés. Ce terme n'est aucunement limitatif de la nature et de la fonction de cette couche. Dans un mode de réalisation illustré en figure 9 décrit par la suite, on verra en effet que la couche à graver fait office de masque dur. Les termes « substrat », « couche à graver » et « couche sous-jacente » sont ainsi équivalents.

Le substrat 410 est par exemple en silicium 410.

La couche de masquage 420 est une couche dans laquelle on peut former des motifs par l'un quelconque des procédés de lithographie.

Dans les exemples suivant, décrits en référence aux figures 4 à 9, la couche de masquage 420 est un masque dur ou une couche de résine, de préférence associée à une couche tampon comme cela sera décrit par la suite.

Selon un exemple de réalisation, la couche de masquage 420 est formée d'une résine imprimable ou photosensible.

De manière plus générale, on qualifie de résine un matériau organique ou organo-minéral pouvant être mis en forme par une exposition à un faisceau d'électrons, de photons ou de rayons X ou mécaniquement. On peut citer à titre d'exemple de résines classiquement employées en microélectronique, les résines à base de polystyrène (PS), de méthacrylate (par exemple le Polymethyl methacrylate PMMA), d'Hydrosilsesquioxane (HSQ), de polyhydroxystyrène (PHS) etc.

La couche de masquage 420 déposée sur le substrat 410 présente, selon cet exemple de réalisation, une épaisseur 423 allant de 100 nanomètres (nm = 10⁻⁹ mètre) à quelques microns (micron ou µm = 10⁻⁶ mètre). L'épaisseur de cette couche de masquage 420, par exemple en résine, dépend de la forme et des dimensions critiques (CD) finales de la structure souhaitée et notamment du nombre d'étapes implantation et de trimming nécessaires. Le matériau de la couche de masquage 420 et son épaisseur sont choisies de manière à ce que cette couche de masquage 420 déposée ne soit pas être intégralement consommée lors des étapes successives de trimming. Par exemple, si cette couche de masquage 420 est en résine et si le trimming consomme la résine sensiblement à la même vitesse, verticalement et latéralement, il faudra prévoir une épaisseur de résine supérieure à la largeur (dans le plan du substrat) de l'ouverture maximale que l'on veut réaliser dans cette résine. Typiquement, l'épaisseur de résine déposée est de l'ordre de 500 nm.

La définition des motifs initiaux 421 dans la résine 420 se fait à l'aide d'étapes de photolithographie conventionnelle utilisant, par exemple, des équipements d'insolation fonctionnant dans l'ultra-violet (UV) c'est-à-dire de type : I-line 365 nm, DUV 248 nm, DUV 193 nm, ou toute autre technique de lithographie, par exemple, à faisceaux d'électrons ou e-beam, auto-alignée ou DSA, ou encore la lithographie par nano impression. Le choix est fait en fonction de la complexité et des dimensions 425 des motifs initiaux 421 à former.

Si la couche de masquage 420 est un masque dur par exemple en SiO2, en SiN ou en TiN, on utilise également les techniques conventionnelles pour définir le motif initial qui sera ensuite élargi après chaque implantation. Typiquement on dépose une couche de résine sur la couche de masquage 420 formant un masque dur, puis on définit un motif initial par photolithographie dans la résine avant de transférer ce motif initial dans la couche de masquage 420 formant un masque dur.

Selon ce mode de réalisation d'un profil en marches d'escalier, la distance à ménager entre deux motifs 421 voisins doit être au moins supérieure à deux fois l'élargissement final généré, à partir du motif initial, par toutes les étapes de trimming décrites ci-après.

Comme montré sur la figure 4b on peut alors procéder à une première implantation 430 de tout type d'espèces permettant de modifier l'état du matériau de la couche à graver 410.

Les paramètres d'implantation, en particulier l'énergie communiquée aux ions, la durée et la dose d'implantation sont prévus de sorte que les zones implantées 411 puissent être gravées sélectivement par rapport aux zones non-implantées 412.

L'implantation consiste à implanter dans la couche à graver 410 des ions sans provoquer de dislocation de sa structure atomique telle qu'elle entraînerait une pulvérisation de la matière implantée.

Selon un mode de réalisation privilégié, l'implantation permet de rendre amorphe le substrat 411 au droit des motifs initiaux 421 qui ont été définis dans la couche de masquage 420.

Il s'agit typiquement, comme déjà mentionné plus haut, d'une implantation d'ions à partir d'hydrogène (H2) qui entraîne une modification du matériau de la zone 411. On pourra également utiliser l'argon (Ar), l'azote (N2) ou l'hélium (He).

L'implantation est réalisée de manière anisotrope, de préférence selon au moins une direction d'implantation sensiblement perpendiculaire au plan dans lequel s'étend la couche à graver ou un substrat sur lequel est disposée la couche à graver. Sur les figures, la direction privilégiée d'implantation est la direction Z.

La couche de masquage 420 est de préférence choisie de manière à ce qu'elle empêche la modification de la couche à graver 410 située au droit de la couche de masquage 420. Ainsi, les ions ne traversent pas la couche de masquage 410 pour pénétrer dans la couche à graver 410.

Selon un mode de réalisation, le matériau de la couche de masquage empêche aux ions de la traverser. Selon un autre mode de réalisation, c'est l'épaisseur de la couche de masquage qui est réglée de manière à ce que les ions restent piégés en son sein sans pénétrer dans la couche à graver sous-jacente.

Ainsi, les ions modifient la couche à graver 410 uniquement au droit des ouvertures formées dans la couche de masquage 420.

En ce qui concerne l'équipement d'implantation, plusieurs choix sont possibles :
- on peut par exemple utiliser un réacteur de gravure sèche dans lequel on forme un plasma et plus particulièrement ceux dits à couplage inductif ou capacitif ;
- ou alors un implanteur classique dit à ligne de faisceau ;
- ou encore un implanteur par immersion qui combine les deux techniques précédentes.
Le choix de l'implanteur dépend du type de structure à réaliser et surtout de la profondeur 413 à implanter dans le substrat.

Dans le cas d'utilisation d'un réacteur de gravure, la profondeur d'implantation des ions est limitée à quelques dizaines de nanomètres. Typiquement, l'implantation peut se faire sur une profondeur allant de quelques Angstrôms (10⁻¹⁰ mètres) jusqu'à un maximum de 100 nm. Une implantation en formant un plasma de type CH4/He, c'est-à-dire méthane/hélium, dans une proportion de 1/50 de ces composés, est dans ce cas préférée car ce type de plasma offre une sélectivité de gravure infinie vis-à-vis de la résine (aucune gravure significative n'est observée pendant l'implantation) dans le cas où la couche de masquage 420 est en résine. Dans le cas d"utilisation d'hydrogène on observe au contraire que celui-ci réagit chimiquement avec la résine et la grave pendant l'implantation altérant ainsi les dimensions 425 des motifs préalablement définis par photolithographie comme on l'a vu ci-dessus. Par ailleurs, l'avantage d'utiliser un réacteur de gravure pour l'implantation est que la modification du substrat, son amorphisation, se fait sans discontinuités sur toute la profondeur 413 implantée, c'est-à-dire depuis la surface jusqu'à la profondeur maximale de la zone implantée. Ainsi l'étape de nettoyage qui va suivre et qui est décrite ci-après est très efficace pour retirer tout le film modifié.

Avec un implanteur classique on peut implanter des ions à une profondeur plus élevée, qui peut atteindre plusieurs centaines de nanomètres. Néanmoins, l'inconvénient des implanteurs classiques réside dans le fait qu'il est difficile d'implanter en surface. En effet avec les implanteurs classiques il existe une énergie minimale de l'ordre de 1 keV (kilo électronvolt) qui provoque inévitablement une pénétration des ions implantées dans le substrat. Les ions se trouvent donc à distance de la surface de ce dernier, même si cela reste à faible profondeur. Il existe ainsi une zone entre la surface et cette profondeur dépourvue ou avec un très faible taux d'espèce implantée. Cela ne permet donc pas qu'une modification en surface, de l'ordre de quelques nanomètres, puisse se faire.

La profondeur minimale d'implantation dans ces conditions est d'environ 20 nm pour des ions hydrogène et de 5 nm pour une implantation à partir d'azote.

La modification de la couche à graver ne s'effectue alors pas de manière parfaitement continue depuis la surface de cette couche.

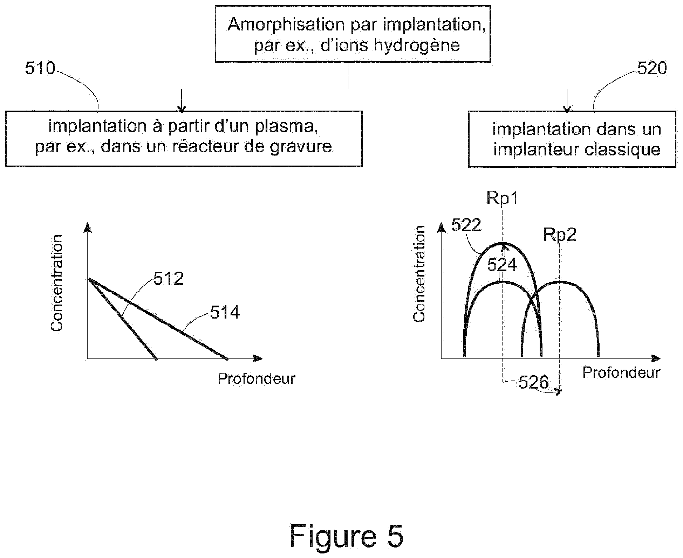

Des profils d'implantation d'ions hydrogène obtenus, d'une part, à partir d'un plasma dans un réacteur de gravure 510 et, d'autre part, dans un implanteur classique 520, sont représentés pour comparaison sur la **figure 5****.** Dans le premier cas, on notera que la concentration d'ions décroit linéairement 512 depuis la surface où elle est donc la plus élevée. En réglant le plasma pour que les ions acquièrent une plus forte énergie on atteint des profondeurs plus élevées avec toujours un profile linéaire décroissant 514.

Dans le cas d'un implanteur classique 520, l'implantation se fait autour d'une profondeur moyenne (Rp) où la concentration est maximale avec un profil gaussien de part et d'autre 522. Il faut alors procéder à plusieurs implantations à des énergies différentes et donc des profondeurs différentes (Rp1, Rp2) pour couvrir toute l'épaisseur à modifier du substrat. Des doses plus élevées permettent d'augmenter la concentration 524 des ions implantés. Avec une même dose on atteint des profondeurs plus élevées 526 en communiquant aux ions une énergie plus grande. De manière conventionnelle la dose exprime le nombre d'atomes implantés dans la matière par centimètres carrés.

Dans le cadre de la présente invention on pourra utiliser les méthodes connues de l'homme du métier et logiciels (SRIM, TRIM, CTRIM...) qui permettent de simuler en fonction des conditions d'implantations (espèces implantées, matériau implanté, dose, énergie, temps d'exposition de la plaque au faisceau d'ions etc.) l'implantation résultante et notamment la profondeur d'implantation. La figure 7 est un exemple décrivant différentes conditions d'implantation dans du Si ou du SiN. Sur cette figure Rp est la profondeur moyenne d'implantation et delta Rp est la hauteur de la zone implantée.

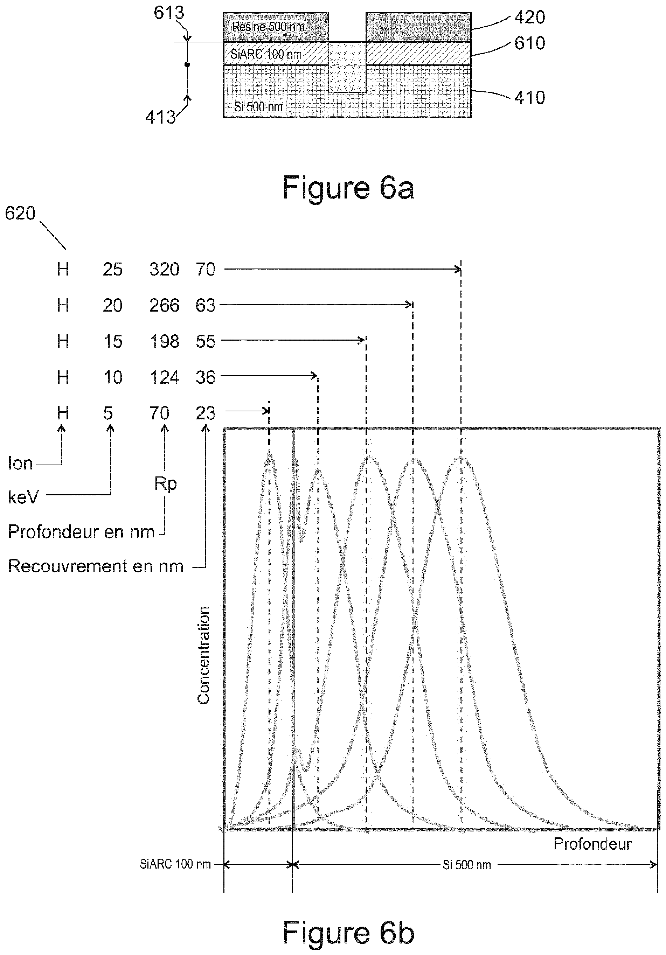

Une solution permettant d'utiliser un implanteur classique et ainsi de pallier le problème des faibles énergies délivrées par ce type d'équipement est d'ajouter une «couche tampon » ou « buffer layer » 610 entre la couche de masquage 420, typiquement en résine et le substrat de silicium 410. Cette solution est décrite par la **figure 6** qui est composée des figures 6a et 6b.

L'épaisseur 613 de la couche tampon 610, qui est au minimum 30 nm, permet alors d'implanter jusqu'en surface le substrat 410 même avec des ions accélérés avec une énergie de seulement 1keV. Dans ce type de réacteur, l'implantation est réalisée à une profondeur donnée, notée Rp comme précédemment. Autour de cette profondeur Rp, la zone d'implantation s'étale typiquement sur quelques dizaines de nanomètres. Pour obtenir une modification continue du substrat, depuis sa surface jusqu'à la profondeur souhaitée, il est alors nécessaire d'assurer un recouvrement des profondeurs modifiées du substrat après chaque étape d'implantation.

Ainsi lors de l'implantation de la couche à graver faite par exemple en silicium, la couche tampon 610 recouvre la couche à graver 410.

D'autres avantages liés à la présence de cette couche tampon 610 lors de l'implantation seront détaillés par la suite en référence aux figures 4 présentant les différentes étapes du procédé de formation des motifs dans la couche à graver.

Dans l'exemple de la figure 6 la couche tampon 610 est faite de SiARC, un matériau anti réfléchissant couramment utilisé en lithographie. Elle est dans ce cas d'une épaisseur 613 de 100 nm pour une implantation dans le silicium constituant le substrat qui s'étend sur une profondeur 413 de 350 nm.

Comme on le voit sur la figure 6b on procède dans cet exemple à cinq implantations successives d'ions hydrogène (H) avec des énergies entre 5 et 25 keV et une même dose de 10¹⁵ atomes/cm². Les conditions sont calculées pour qu'il y ait recouvrement des profils d'implantation. Les implantations sont obtenues à des profondeurs et avec des recouvrements comme indiqué dans le tableau 620. D'autres conditions d'implantation permettent de définir des profondeurs implantées et des recouvrements différents.

Comme mentionné ci-dessus le choix d'un implanteur peut aussi se porter sur l'utilisation d'un plasma par immersion qui combine les deux précédentes techniques et qui permet de faire varier la profondeur d'implantation de quelques Angstrôms à plusieurs centaines de nanomètres.

En se référant de nouveau à la figure 4, entre deux étapes d'implantation on procède à une étape de trimming 440 comme illustré sur la figure 4c, étape au cours de laquelle les dimensions horizontales du motif initial 421 sont augmentées

Ainsi, c'est bien la même couche de masquage 420 qui est conservée entre deux étapes d'implantation. De même c'est bien le motif utilisé lors d'une première étape d'implantation qui est élargi avant d'effectuer une deuxième étape d'implantation. Après implantation au droit d'un motif porté par la couche de masquage 420, il n'y a donc pas de retrait de cette couche de masquage 420 pour en redéposer une autre portant un autre motif. La même couche masquage 420 est conservée et seule l'au moins un motif qu'elle porte est élargi.

Naturellement, il y a en général souvent un minimum de consommation verticale lors de l'étape de trimming, en particulier lorsque la couche de masquage 420 est en résine. On prévoit alors l'épaisseur de résine initiale en conséquence. Par exemple si la vitesse d'attaque verticale est sensiblement égale à la vitesse d'attaque latérale alors l'épaisseur de résine doit être supérieure à la largeur totale trimmée. Ce type de gravure, qui est couramment pratiqué par l'industrie de la microélectronique, est réalisé dans un réacteur de gravure à couplage inductif ou capacitif en utilisant une chimie à base de bromure d'hydrogène et d'oxygène (HBr/O2) ou de chlore et d'oxygène (Cl2/O2). Le débit d'oxygène permet de contrôler la vitesse de trimming c'est-à-dire la consommation latérale de résine. Par exemple, dans un réacteur à couplage inductif et dans les conditions suivantes : pression 10 milliTorr ; puissance de la source 500 Watts ; puissance de polarisation 50 Watts et avec 15% d'oxygène dans le mélange HBr/O2 ; on induit une consommation latérale de la résine de 80 nm par minute. Dans les mêmes conditions et avec une proportion d'oxygène de 45% dans le mélange gazeux on induit une consommation latérale de résine de 120 nm par minute.

On notera que dans le cas où l'implantation est réalisée à partir d'un plasma par immersion, l'étape de trimming peut être réalisée dans le même réacteur que celui servant à l'implantation en utilisant la chimie précédemment décrite. L'utilisation de ce type de réacteur présente donc l'intérêt de pouvoir réaliser les étapes d'implantation 430 et de trimming 440 dans le même équipement, simplifiant de ce fait le procédé et réduisant les coûts d'obtention. L'industrialisation du procédé selon l'invention en est donc facilitée.

Les opérations précédentes, trimming et implantation, peuvent être répétées à partir du motif initial 421 afin d'obtenir un profil d'implantation des ions dans le substrat 410 en marches d'escalier 451 comme celui illustré sur la figure 4d. En agissant sur les conditions de trimming et d'implantation à chacune des étapes on peut obtenir des profils avec des rapports de forme très différents comme celui 452 illustré par comparaison sur la figure 4g.

Sur les figures 4d et 4g, les zones modifiées par implantation après chaque définition de motif dans la couche de masquage 420 sont référencées 411, 411', 411", 411'''. Naturellement au cours de l'implantation de la zone 411', une partie supérieure de la zone 411 modifiée au cours de l'étape précédente d'implantation est à nouveau implantée, l'implantation étant effectuée pleine plaque. De même au cours de l'implantation de la zone 411", une partie supérieure des zones 411 et 411' est à nouveau implantée.

Selon le mode de réalisation illustré en figure 6a, 6b et décrit précédemment, la couche de masquage 420 surmonte une couche tampon 610.

Selon un mode de réalisation la couche tampon 610 est en un matériau non carboné, tel que par exemple le SiARC (revêtement anti-réfléchissant), le SixOy (SiO2 par exemple) ou le SixNy (SiN par exemple), ou encore un masque métallique tel que le TiN. Dans ce cas la couche de masquage 420 est de préférence en résine.

Selon un autre mode de réalisation la couche tampon 610 est en matériau carboné tel que de la résine. Dans ce cas, la couche de masquage 420 est de préférence en résine et la couche tampon 610 forme alors une épaisseur résiduelle dans le fond du motif présent dans la couche de masquage 420. Un exemple particulièrement avantageux de réalisation du motif initial est une réalisation par nano-impression. Cette technique peu couteuse et rapide permet également de définir précisément un résidu en fond de motif formant la couche tampon. Ce résidu de résine, habituellement perçu comme un inconvénient de la nano-impression, est ici utilisé comme couche tampon protégeant la couche à graver 410 lors de l'implantation.

Comme indiqué précédemment, cette couche tampon 610 n'est pas gravée, ou pas entièrement gravée, lors de l'étape d'élargissement du motif présent dans la couche de masquage 420 en résine. Ainsi cette couche de tampon 610 demeure au-dessus de la couche à graver 410 après élargissement du motif présent dans la couche de masquage 420. La couche à graver 410 n'est ainsi pas à nu lors de l'implantation.

Ce mode de réalisation présente un avantage considérable. En effet, il s'est avéré que l'implantation 430 en l'absence d'une couche tampon, en particulier à travers une couche carbonée telle qu'une couche de résine, induit un phénomène qui diminue le contrôle dimensionnel de la forme obtenue au final et qui dégrade la qualité du matériau de résiduel de la couche à graver 410.

Plus précisément, en l'absence d'une couche tampon, lorsque la couche de masquage est carbonée, l'implantation recherchée dans la couche à graver produit inévitablement un bombardement de la surface de la couche de masquage. Cette couche de masquage est ainsi pulvérisée en surface. Ce bombardement tend à rayonner des atomes de carbone initialement présents dans la couche de masquage carbonée. Une partie de ces atomes de carbone est projetée dans la couche à graver, là où elle est à nu. Dans le cadre du développement de la présente invention il s'est avéré que ces atomes de carbone pénètrent dans la couche à graver et forment alors dans cette dernière un film de surface enrichi en carbone. Ce film présente généralement une épaisseur inférieure à 20 nm et plus souvent inférieure à 10nm en fonction de l'énergie du bombardement.

Ainsi, la surface de la couche à graver mise à nu est modifiée par apport de carbone. Du fait de cette modification de la surface de la couche à graver, il n'est alors plus possible de venir correctement graver par gravure humide la zone implantée.

En effet une gravure humide par une solution d'hydroxyde d'ammonium tétra-méthyle (TMAH) ou d'acide fluorhydrique (HF) par exemple, ne permettra pas de retirer les zones modifiées par implantation si elles ont été enrichies en carbone. Il s'ensuit que les motifs de la couche de masquage ne sont pas fidèlement reproduits dans la couche à graver. En particulier les flancs des motifs de la couche à graver ne sont pas situés au droit de ceux de la couche de masquage. Par ailleurs, les flancs des motifs de la couche à graver ne sont pas verticaux.

Le contrôle dimensionnel de la forme complexe à réaliser ainsi que la qualité du matériau résiduel sont donc fortement dégradés.

Dans un cas plus extrême, la solution de gravure ne parvient pas à graver la couche à graver de silicium si la surface de cette dernière a été trop enrichie en carbone.

L'invention, en prévoyant une couche tampon 610 qui évite de mettre à nu la couche à graver 420 au droit de la partie élargie du motif défini dans la couche de masquage 420, on parvient à protéger la couche à graver 420 de tout apport de carbone. En effet lors de l'implantation le carbone rayonné dans le fond du motif s'implante dans la couche tampon. L'épaisseur de cette dernière est choisie de manière à ce que les atomes de carbone ne la traverse pas. Ainsi la couche tampon stoppe et piège les atomes de carbone.

Par exemple si la couche tampon 610 est en résine, une épaisseur, avant implantation, de préférence supérieure à 20nm et de préférence supérieure à 30nm sera suffisante. Il en est de même si la couche tampon 610 est en SixOy, SixNy ou s'il s'agit d'un masque métallique. Dans ces derniers cas, la couche tampon 610 présente une épaisseur, avant implantation, de préférence supérieure à 20nm.

Comme cette couche tampon 610 doit couvrir la couche à graver 410 au cours des différentes séquences comprenant chacune (1) une étape élargissement du motif initial et (2) une étape d'implantation, si cette couche tampon à tendance à être gravée lors de l'étape (1) d'élargissement, il faut naturellement prévoir une épaisseur initiale suffisante. Par exemple pour une couche tampon 610 en résine, si une épaisseur des 5nm est gravée à chaque étape d'élargissement et que l'on prévoit 10 séquences comprenant chacune (1) une étape élargissement et (2) une étape d'implantation, il faudra alors prévoir initialement une épaisseur de couche tampon 610 d'au moins 70nm pour que lors de l'implantation de la dixième séquence, il reste au moins 20 nm de résine au-dessus de la couche à graver 410.

La couche tampon 610 recouvrant la couche à graver 420 est retirée, par exemple lors de la gravure de cette dernière.

Grâce à cette couche tampon 610, les flancs des motifs de la couche à graver 420 sont verticaux. Le contrôle dimensionnel de la forme complexe réalisée ainsi que la qualité du matériau résiduel sont fortement améliorés.

Un autre mode de réalisation qui permet d'éviter l'apport de carbone dans la couche à graver et qui permet donc d'améliorer le contrôle dimensionnel des motifs finaux, comprend l'utilisation d'une couche de masquage 420 formant un masque dur non carboné à la place d'une couche de masquage carbonée.

Il peut d'agir d'un masque dur inorganique, par exemple en SiOx ou en SiNx et plus particulièrement en SiO2 ou SiN. Il peut également s'agir d'un masque dur métallique, par exemple en TiN.

Ce masque dur n'étant pas carboné, il ne rayonne pas d'atomes de carbone dans la couche à graver 420 lors de l'implantation. Il ne se forme alors pas à la surface de cette dernière un film enrichi en carbone.

Ces deux modes de réalisation, utilisant une couche tampon 610 et un masque dur ont pour avantage de permettre un retrait des zones modifiées de la couche à graver par TMAH.

Un avantage d'une gravure humide est d'avoir une meilleure sélectivité de gravure avec la partie non implantée qu'avec d'autres types de gravure notamment par plasma. Une gravure par plasma est en effet beaucoup plus agressive du fait du bombardement. L'invention permet d'obtenir un meilleur contrôle dimensionnel de la forme complexe réalisée et une meilleure qualité du matériau résiduel.

À l'étape suivante, quand on a obtenu le profil souhaité, on procède au retrait de la couche de masquage 420. Cette étape est parfaitement connue et maitrisée par l'homme du métier. Lorsque la couche de masquage 420 est en résine son retrait est classiquement réalisée dans une chambre de gravure en utilisant une chimie à base d'oxygène ou par voie humide en utilisant une chimie couramment employée dite SPM(H2SO4:H2O2) à base d'acide sulfurique (H2SO4) et d'eau oxygénée (H2O2).

Les figures 4e et 4h illustrent le résultat de l'étape suivante où l'on procède au retrait de toute la zone 461, 462 du substrat qui a été modifiée, c'est-à-dire le plus souvent amorphisée, par les opérations successives d'implantation d'ions.

Les conditions de retrait des zones modifiées, 461 et 462, sont choisies pour qu'il n'y ait pas ou peu de consommation des zones non modifiées 412 du substrat 410, c'est à dire avec une consommation du matériau non modifié qui n'excède pas quelques nanomètres par minute. Typiquement, si le substrat 410 est fait de silicium cristallin, on procède au retrait du silicium amorphisé par les implantations, sélectivement au silicium cristallin, en utilisant une solution d'hydroxyde d'ammonium tétra-méthyle (TMAH) ou d'acide fluorhydrique (HF) sous atmosphère d'oxygène. Le silicium cristallin n'est pas ou peu consommé par ce type de nettoyage.

Les figures 4f et 4i illustrent le résultat d'un lissage des profils en marches d'escalier qui peut être effectué après l'étape précédente de retrait du silicium amorphisé. On procède alors à une oxydation thermique du silicium du substrat afin de former une couche d'oxyde dans une gamme d'épaisseur allant par exemple de 10 nm à 2 µm. Cette opération de croissance d'oxyde thermique est suivie d'une désoxydation et nettoyage par exemple par voie humide dans une solution d'acide fluorhydrique (HF). Cette étape permet avantageusement d'obtenir un lissage des parois du profil ainsi formé et/ou d'adapter plus précisément ses dimensions finales.

Ce profil est par exemple apte à former un moule, dont une application possible est la réalisation par impression nanométrique d'une lentille asphérique.

On pourra effectuer une opération de lissage des marches d'escaliers. Cette opération de lissage est de préférence effectuée par oxydation thermique suivie d'une désoxydation. En fonction de l'épaisseur d'oxyde de silicium que l'on souhaite réaliser les conditions de croissance de cet oxyde thermique pourront être par exemple les suivantes :
- oxydation thermique d'épaisseur 200 nm à l'aide d'un recuit à 1000°C sous atmosphère oxydante pendant 20 minutes ;
- oxydation thermique d'épaisseur 1000 nm à l'aide d'un recuit à 1000°C sous atmosphère oxydante pendant 3 heures.
Le retrait du SiO2 ainsi formé pourra se faire par dissolution de l'oxyde par voie humide dans une solution d'acide fluorhydrique (HF) diluée à 10%.

La **figure 8** composée des figures 8a à 8d montre comment réaliser un profil donné en mettant un mode de réalisation de l'invention.

La forme à réaliser avec le procédé décrit avec la figure 4 est, par exemple, celle 810 montrée sur figure 8a. On considère que l'utilisateur fixe le nombre d'étapes d'implantation à réaliser. Dans cet exemple on choisit d'effectuer six étapes d'implantation. On peut alors découper « fictivement » en autant de profondeurs différentes 820 la forme à réaliser. Cela est fait en tranches de même épaisseur, ou non, en fonction des conditions d'implantation choisies pour chacune des tranches. Les profondeurs sont notées z1, z2, z3, z4, z5 et z6 dans cet exemple. Ces profondeurs sont prises selon la direction Z. L'intersection de ces plans en z « fictifs » avec la forme à réaliser 810 permet de déterminer la largeur des différentes motifs successifs nécessaires à chaque implantation et donc les dimensions à trimmer 830 notées ici x1, x2, x3, etc., par rapport au motif 421 qu'il faut définir par photolithographie et graver initialement dans la couche de masquage 420 par exemple en résine comme déjà décrit dans la figure 4. Les dimensions à trimmer sont prises selon la direction X.

Comme illustré en figure 8b ; le motif 421 permet une modification par implantation du substrat sur la profondeur z1. Comme illustré en figure 8c ; l'élargissement du motif 421 sur une dimension x1 permet de créer un motif élargi. Cet élargissement est suivi d'une modification par implantation du substrat sur la profondeur z2. Comme illustré en figure 8d ; une nouvelle opération de trimming permet un élargissement du motif précédent sur une dimension x2. Cet élargissement est suivi d'une modification par implantation du substrat sur la profondeur z3. Le procédé peut ainsi être poursuivi en répétant cette séquence d'opérations de trimming et d'implantation.

Cette procédure peut être appliquée pour réaliser n'importe quel profil 810.

La **figure 9****,** qui est composée des figures 9a à 9d, illustre une autre application de l'invention qui est utilisée dans cet exemple pour réaliser une structure dite « double damascène » très largement employée par toute l'industrie de la microélectronique depuis que le cuivre a remplacé l'aluminium pour l'interconnexion des circuits intégrés.

La figure 9 montre les étapes de réalisation d'une ligne d'interconnexion qui est avantageusement dans ce cas auto alignée sur les contacts verticaux ou vias (également désignés trous de contact) destinés à permettre l'interconnexion avec les autres plans d'interconnexion situés au-dessous (non représentés sur les figures).

Dans l'approche conventionnelle, une structure double damascène est réalisée à partir d'une succession d'étapes comprenant : une première photolithographie des trous de contact ; une gravure sèche des trous de contact par plasma ; puis, il faut procéder à une seconde étape de photolithographie de la ligne suivie d'une seconde étape de gravure sèche de celle-ci (gravant également les contacts).

L'invention permet de n'utiliser qu'une seule étape de photolithographie pour la réalisation de ce type de structure qui se trouve donc être auto alignée. La position des vias vis-à-vis de la ligne d'interconnexion ne dépend plus alors du bon positionnement de la seconde photolithographie. Les étapes du procédé, adapté à la réalisation d'une structure double damascène de cet exemple de mise en oeuvre de l'invention, sont celles déjà décrites dans les figures précédentes et rappelées ci-après.

Comme montré sur a figure 9a, comprenant à gauche une vue en coupe et à droite une vue du dessus, une couche de résine 420 est tout d'abord déposée sur une couche 410 d'un matériau destinée à former un masque dur. Dans ce mode de réalisation, la couche à graver est le masque dur 410.

On effectue ensuite une étape de photolithographie des trous de contact 421 dans la résine 420.

De préférence, la couche de résine 420 a une épaisseur équivalente à l'épaisseur du masque dur formé de la couche à graver 410, c'est-à-dire, de quelques dizaines à plusieurs centaines de nanomètres.

Le masque dur 410 servira ensuite au transfert de la structure double damascène dans un substrat sous-jacent 910. Le masque dur 410 est par exemple formé de nitrure de silicium tel que le Si3N4 ou plus généralement le SiNx ou le SixNy. Le masque dur peut également être du type SixOy ou SiOx. Il peut également s'agir d'un masque métallique tel que le TiN. Couramment utilisé, le nitrure de silicium sera préférentiellement choisi pour un transfert dans un substrat sous-jacent 910 par exemple en matériau semi-conducteur tel que le silicium ou en matériau isolant tel que le SiO2 ou encore le SiOCH.

Le transfert des trous de contact 421 dans le masque dur 410 est ensuite réalisé par implantation 430 d'ions comme précédemment décrit. Comme montré sur la figure 9b, cette étape d'implantation 430 reproduit la forme et le pas de répétition des contacts 820, au nombre de trois dans cet exemple, par modification du matériau constituant le masque dur 410. Les conditions d'implantation dépendent de l'épaisseur du masque dur 410 à implanter.

Ensuite, comme montré sur la figure 9c, la réalisation de la ligne d'interconnexion 830 des trois contacts de cet exemple est d'abord effectuée en obtenant que les trous de contact 421 réalisés dans la résine 420 deviennent jointifs.

Ceci est effectué, comme précédemment, grâce à une opération de trimming 440, c'est-à-dire grâce à une consommation horizontale de la résine 420 par exemple dans un plasma à base d'oxygène sans opération de photolithographie supplémentaire.

Comme montré sur la figure 9d, l'empreinte de la ligne 830 est ensuite transférée partiellement dans l'épaisseur du masque dur 410. Pour ce faire on procède à une nouvelle opération d'implantation 430 qui est adaptée pour ne modifier qu'une partie supérieure 813 de la couche formant le masque dur 410. L'implantation 430 est obtenue en utilisant les différentes techniques précédemment mentionnées, les conditions d'implantation dépendent notamment de l'épaisseur qui aura été choisie pour former la couche 410 constituant le masque dur.

La dernière étape, non représentée sur la figure 9, consiste à d'abord enlever la résine 420 en utilisant les techniques conventionnelles mises au point par l'industrie de la microélectronique, par exemple par voie humide dans une solution acide ou par voie sèche dans un plasma.

Ensuite, les zones 411 du masque dur 410 qui ont été modifiées par implantation d'ions, c'est-à-dire les trous de contact et leur ligne d'interconnexion, sont gravées sélectivement vis-à-vis des zones 412 du masque dur 410 qui sont restées non modifiées. Cela peut se faire par voie humide ou par voie sèche. De préférence, si le masque dur est du nitrure de silicium, on choisira un nettoyage humide dans une solution d'acide fluorhydrique (HF) diluée à 1%.

On peut ensuite transférer dans le substrat sous-jacent 910 le profil formé dans le masque dur 410.

Dans les exemples décrits ci-dessus en référence aux figures 3 à 9, il a été indiqué que la couche de masquage 420 est en résine. Dans un mode de réalisation alternatif qui est applicable à tous les exemples décrits précédemment la couche de masquage 420 est formée d'un masque dur.

Avantageusement, on utilisera un masque dur pour réaliser des motifs de petites dimensions latérales nécessitant donc une faible ouverture totale dans le masque et donc une faible épaisseur de masque.

Le masque dur est par exemple en SiOx ou en SiNx.

Avantageusement pour réaliser des motifs plus larges, on pourra prévoir de protéger le masque de la gravure verticale. Pour cela on pourra prévoir une ou plusieurs couches de protection sur la couche servant de masque. Par exemple on pourra protéger un masque de SiOx par une couche de SiNy de très faible épaisseur (typiquement de 1 à 5nm par exemple) et vice versa. Le matériau de la couche de protection est choisi de manière à présenter une sélectivité de gravure par rapport au matériau de la couche de masquage. La couche de protection de par sa très faible épaisseur sera sensiblement transparente lors de l'implantation.

A titre d'exemple, le SiOx pourra être gravé sélectivement par rapport au nitrure par gravure HF vapeur, le SiNy pourra être gravé sélectivement par rapport à l'oxyde par gravure à base d'H3PO4.

Ainsi, le matériau de la couche de protection est choisi de manière à empêcher ou à réduire une consommation verticale du masque dur lors de l'étape d'élargissement du motif formé dans la masque dur.

Lors de la création du motif on grave à la fois la couche de masquage et la couche de protection. Ensuite pour les étapes de gravure latérales, on ne grave que la couche de masquage, la couche de protection formant alors un léger surplomb ne gênant pas la gravure latérale « sous » la couche de protection.

Comme indiqué ci-dessus l'invention est particulièrement avantageuse dans le cas où la couche à graver 410 est en silicium ou dans l'un des matériaux suivants : le silicium germanium, le germanium, le nitrure de silicium, le saphir, le quartz.

Selon encore un autre mode de réalisation la couche à graver est en oxyde de silicium carboné et hydrogéné (SiOCH). Il peut s'agir de SiOCH poreux ou dense. Ce matériau présente pour avantage d'avoir une très faible permittivité, en particulier lorsqu'il est poreux.

Tous les modes de réalisation décrits ci-dessus sont applicables au SiOCH. Les étapes principales d'un mode de réalisation particulièrement avantageux vont être décrites ci-dessous.
1. Empilement : Une couche de résine formant la couche de masquage 420 est déposée sur une couche à graver 410 de SiOCH. Entre la couche de masquage 420 et la couche à graver 410 en SiOCH on forme une couche protectrice, par exemple un oxyde (SiO2) ou un nitrure (SiN). Cette couche protectrice sera utilisée pour faciliter la lithographie comme cela sera explicité ci-dessous. Elle permet également de protéger le SiOCH lors de l'implantation, ce matériau étant de faible densité il est facilement pulvérisé pendant l'implantation.
2. Lithographie : on effectue une étape de lithographie par nano-impression (NIL). Cette technique est une bonne alternative aux procédés de lithographie conventionnels. Néanmoins l'un des inconvénients de cette technique est qu'elle ne permet pas aux motifs du moule d'atteindre l'interface SiOCH/résine pendant le pressage. Il subsiste en effet dans le fond des motifs un résidu de résine. Par ailleurs, l'utilisation de la gravure sèche pour ouvrir la résine résiduelle engendre des modifications de dimensions des motifs initiaux. Ici, l'épaisseur résiduelle du résidu en fond de motif ne présente aucun frein car l'implantation la traverse pour atteindre le matériau cible. Par ailleurs, comme cela a été décrit ci-dessus, ce résidu de résine, bien dimensionné en épaisseur, forme une couche tampon permettant de stopper les atomes de carbone arrachés à la surface de la couche de résine et qui ont tendance à pénétrer dans la couche à graver 410 de SiOCH.
3. Implantation : L'implantation peut être réalisée dans un équipement d'implantation ionique à faisceau d'ions ou à immersion plasma. L'énergie et la dose d'implantation sont définies en fonction du profil et de la profondeur souhaités. Des simulations sur appliquette Crystal TRansport of Ions in Mater (C-trim) permettent de prédire la profondeur d'implantation dans les matériaux.

L'implantation ionique engendre des modifications dans le matériau, notamment la rupture de certaines liaisons. Sous l'effet de l'implantation, le SiOCH perd ses groupements méthyle et tend vers une structure proche de ou semblable à celle d'un SiO2. Ceci permet de créer une forte sélectivité lors de la gravure humide.

Dans le cadre de la présente invention il a été remarqué que, quelle que soit l'espèce de l'ion implanté, une pulvérisation du SiOCH a lieu. L'intégration de la couche protectrice citée précédemment s'avère alors particulièrement avantageuse.

Dans le cadre du développement de la présente invention, l'Hydrogène s'est avéré particulièrement avantageux. L'hydrogène permet en effet d'avoir une sélectivité très forte quand d'autres espèces telles que l'Argon manifestent une résistance « infinie » à la gravure humide au HF.

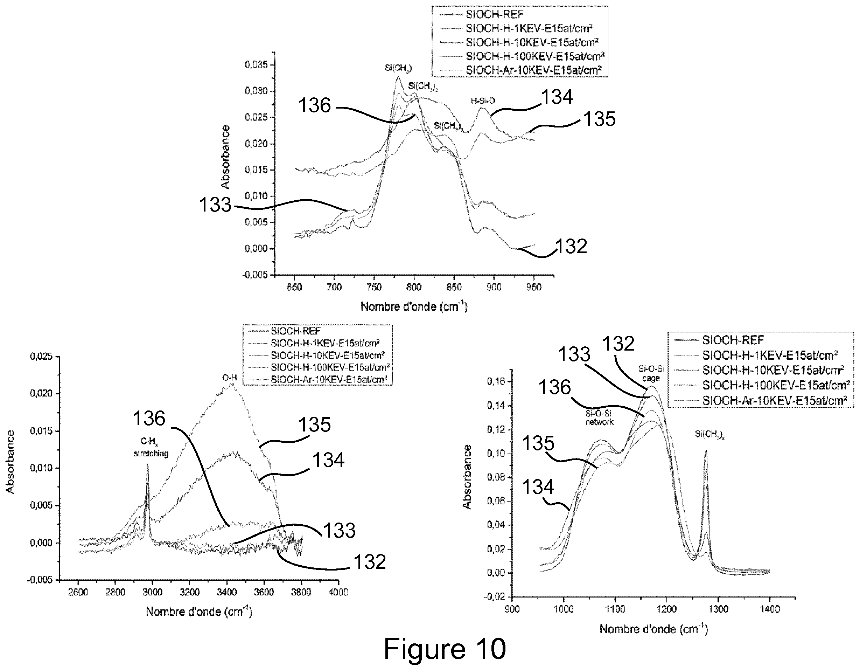

La **figure 10** illustre la structure du SiOCH après l'implantation d'H et d'Ar. La dose étant toujours maintenue à 1.E15at/cm², trois énergies sont testées pour l'Hydrogène 1kev, 10kev, et 100kev, et une pour l'Argon : 10kev.

Sur la figure 10, la courbe 132 correspond à du SiOCH de référence c'est-à-dire non implanté ; la courbe 133 correspond à du SiOCH implanté avec des ions hydrogène et une énergie de 1keV; la courbe 134 correspond à du SiOCH implanté avec des ions hydrogène et une énergie de 10keV ; la courbe 135 correspond à du SiOCH implanté avec des ions hydrogène et une énergie de 100keV ; la courbe 136 correspond à du SiOCH implanté avec des ions argon et une énergie de 10keV.

On remarque dans le cas de l'H, l'apparition de la liaison O-H (bande 2800-3800 cm-1) après implantation ce qui correspond à la prise d'eau du matériau, le SiOCH passe d'un matériau hydrophobe à un matériau hydrophile. La prise d'eau reste peu prononcée pour l'Argon ce qui explique sa résistance à la gravure humide au HF.

On constate également la rupture des groupements méthyle et la formation des liaisons Si-O.

Suite à une première implantation, on élargit le motif. Pour cela on se référera aux explications mentionnées dans les modes de réalisations précédents. Cette étape de trimming permet de mettre à nu une surface additionnelle de la couche de protection.

Suite à cet élargissement, on procède à une nouvelle implantation pour modifier le SiOCH au droit de la partie où la couche de masquage a été retirée lors de l'élargissement. Le SiOCH est ainsi modifiée sur une surface plus étendue. La profondeur d'implantation est moindre qu'à l'étape précédente d'implantation.

Cette séquence comprenant l'étape d'élargissement et l'étape de modification par implantation peut être répétée de nombreuses fois.
4. Retrait de la couche de masquage : Ce retrait est effectué après la dernière séquence comprenant l'étape d'élargissement et l'étape de modification par implantation. Le retrait de la résine peut se faire par voie humide ou sèche. Lors de cette étape la couche protectrice protège avantageusement le SiOCH.
5. Gravure du SiOCH modifié: Cette étape de gravure est de préférence effectuée avec une solution d'HF diluée à 1%. Comme expliqué précédemment l'implantation génère des modifications dans le SiOCH qui se traduisent par l'hydrophilisation du matériau, la rupture des groupements méthyle et enfin la formation des liaisons Si-O. Ceci permet d'avoir une sélectivité infinie par rapport à la zone non modifiée à hauteur d'un temps de gravure inférieur à 240.

Cette étape permet également le retrait de la couche de protection, par exemple en SiN ou SiO2.

La technique décrite ci-dessus pour texturer du SiOCH présente plusieurs avantages :
- Le masque n'est pas métallique mais organique ce qui confère de nombreux avantages en termes de procédé.
- La lithographie par nano-impression utilisée pour créer le motif est peu couteuse et précise. Par ailleurs le résidu de résine dans le fond du motif peut faire office de couche tampon pour protéger la couche de SiOCH contre l'apport non souhaité de carbone lors de l'implantation comme cela a été décrit ci-dessus. Par ailleurs, elle protège le SiOCH lors du retrait de la résine.
- La gravure se fait par voie humide

Selon un mode de réalisation alternatif, l'enlèvement de la couche de masquage en résine peut être fait lors de l'étape de gravure humide par solution HF, en particulier si l'on utilise une résine à base de Silicium comme l'Hydrogène silsesquioxane (HSQ).

Par ailleurs, toute autre technique de lithographie peut être utilisée pour structurer la résine.

Au vu de la description qui précède, il apparaît clairement que l'invention propose une solution simple, fiable et aisément industrialisable pour réaliser des profils possiblement complexes et nécessitant d'aligner plusieurs opérations de lithographies.

L'invention n'est pas limitée aux modes de réalisations précédemment décrits et s'étend à tous les modes de réalisation couverts par les revendications.

## Revendications

1. Procédé de réalisation de motifs dans une couche à graver (410), à partir d'un empilement comprenant au moins la couche à graver (410) et une couche de masquage (420) surmontant la couche à graver (410), la couche de masquage (420) présentant au moins un motif (421), le procédé étant **caractérisé en ce qu'**il comprend au moins:
a) une étape de modification d'au moins une zone (411) de la couche à graver (410) par implantation d'ions (430) au droit dudit au moins un motif (421) de ladite couche de masquage (420);
b) au moins une séquence d'étapes comprenant :
b1) une étape d'élargissement (440) dudit au moins un motif (421) de ladite couche de masquage (420), ladite couche de masquage (420) ayant été conservée après l'étape de modification afin effectuer l'étape d'élargissement, l'étape d'élargissement (440) étant effectuée de manière à élargir ledit au moins un motif (421) selon un plan dans lequel s'étend principalement la couche à graver (410) ;
b2) une étape de modification d'au moins une zone (411', 411") de la couche à graver (410) par implantation d'ions (430) au droit de l'au moins un motif (421) élargi de ladite couche de masquage (420), l'implantation étant effectuée sur une profondeur inférieure à la profondeur d'implantation de l'étape précédente de modification ;
c) une étape de retrait (461, 462) des zones modifiées (411, 411', 411"), le retrait comprenant une étape de gravure des zones modifiées (411, 411', 411") sélectivement aux zones non modifiées (412) de la couche à graver (410), ladite étape de gravure étant une gravure humide ;
et dans lequel :
- soit la couche de masquage (420) est un masque dur,
- soit la couche de masquage (420) comprend du carbone et l'empilement comprend une couche tampon (610), la couche tampon étant disposée entre la couche de masquage (420) comprenant du carbone et la couche à graver (410), la couche tampon recouvrant la couche à graver (410) lors de l'implantation.

2. Procédé selon la revendication précédente dans lequel la couche de masquage (420) comprend du carbone, l'empilement comprenant une couche tampon (610) qui est disposée entre la couche de masquage (420) comprenant du carbone et la couche à graver (410) et qui recouvre la couche à graver (410) lors de l'implantation et dans lequel la couche de masquage (420) comprend du carbone et dans lequel l'épaisseur (613) de la couche tampon (61), après l'étape d'élargissement et avant l'implantation (430), est suffisante pour former une barrière empêchant, lors de ladite implantation (430), à du carbone provenant de la couche de masquage (420) de pénétrer à l'intérieur de la couche à graver (410).

3. Procédé selon l'une quelconque des deux revendications précédentes dans lequel la couche de masquage (420) comprend du carbone, l'empilement comprenant une couche tampon (610) qui est disposée entre la couche de masquage (420) et la couche à graver (410) et qui recouvre la couche à graver (410) lors de l'implantation et dans lequel le matériau de la couche de masquage (420) et le matériau de la couche tampon (610) sont différents et dans lequel l'étape d'élargissement (440) de l'au moins un motif (421) de la couche de masquage (420) comprend une gravure de la couche de masquage (420) sélectivement à la couche tampon (610), la gravure étant de préférence une gravure anisotrope dont la direction principale est parallèle à un plan dans lequel s'étend principalement la couche à graver (410).

4. Procédé selon l'une quelconque des trois revendications précédentes dans lequel la couche de masquage (420) comprend du carbone, l'empilement comprenant une couche tampon (610) qui est disposée entre la couche de masquage (420) et la couche à graver (410) et qui recouvre la couche à graver (410) lors de l'implantation et dans lequel
- la couche tampon (610) est en un matériau pris parmi les matériaux suivants : SixOy, SiOx, SixNy, SiNx, TiN, SiARC,
ou dans lequel
- la couche de masquage (420) et la couche tampon (610) sont en résine.

5. Procédé selon l'une quelconque des revendications 1 à 2 dans lequel la couche de masquage (420) comprend du carbone, l'empilement comprenant une couche tampon (610) qui est disposée entre la couche de masquage (420) comprenant du carbone et la couche à graver (410) et qui recouvre la couche à graver (410) lors de l'implantation,
dans lequel la couche de masquage (420) et la couche tampon (610) sont en résine, et dans lequel la couche tampon (610) forme un résidu de résine dans un fond du motif (421) de la couche de masquage (420).

6. Procédé selon la revendication 1 dans lequel la couche de masquage (420) est une couche formant un masque dur et dans lequel la couche de masquage (420) est disposée directement au contact de la couche à graver (410) et dans lequel l'étape d'élargissement (440) de l'au moins un motif (421) de la couche de masquage (420) comprend une gravure de la couche de masquage (420) sélectivement à la couche à graver (410), la gravure étant une gravure anisotrope dont la direction principale est de préférence parallèle à un plan dans lequel s'étend principalement la couche à graver (410).

7. Procédé selon l'une quelconque des revendications 1 ou 6, dans lequel la couche de masquage (420) est une couche formant un masque dur et dans lequel on dispose sur la couche de masquage (420) au moins une couche de protection, le matériau de la couche de protection étant choisi de manière à empêcher ou à réduire une consommation verticale du masque dur lors de l'étape d'élargissement (440) du motif (421) formé dans la masque dur.

8. Procédé selon l'une quelconque des revendications précédentes dans lequel l'implantation est effectuée avec un implanteur ou dans lequel l'implantation (430) est effectuée dans un réacteur plasma.

9. Procédé selon l'une quelconque des revendications précédentes dans lequel les étapes b) et c) sont choisies, en particulier l'élargissement (440) de l'au moins un motif (421) et la profondeur d'implantation, de manière à ce que les zones modifiées (411, 411', 411") forment un profil en marches d'escalier et dans lequel après gravure dans la couche à graver (410) d'un profil en marches d'escalier on procède à un lissage (470) dudit profil par oxydation et désoxydation du matériau du substrat.

10. Procédé selon l'une quelconque des revendications précédentes, dans lequel :
- le profil présente le négatif d'une forme de lentille asphérique.
ou dans lequel
- le profil forme un moule configuré pour pénétrer dans une résine imprimable afin d'y transférer par nano-impression le profil.

11. Procédé selon l'une quelconque des revendications 1 à 8 dans lequel préalablement aux étapes a) à c), la couche de masquage (420) comporte une pluralité de motifs formant des ouvertures dans l'épaisseur de la couche de masquage (420) et dans lequel l'étape d'élargissement est effectuée de manière à supprimer le matériau de le couche de masquage (420) séparant au moins deux motifs, de manière à rendre ces au moins deux motifs jointifs après élargissement.

12. Procédé selon l'une quelconque des revendications 1 à 8 dans lequel préalablement aux étapes a) à c), la couche de masquage (420) comporte une pluralité de motifs (421) destinés à former des vias d'interconnexion, dans lequel l'étape d'élargissement est effectuée de manière à joindre (830) au moins certains des vias d'interconnexion et de préférence dans lequel le profil formé dans la couche à graver (410) est ensuite transféré dans une couche sous-jacente (910) recouverte par la couche à graver (410), la couche à graver (410) faisant office de masque dur lors du transfert du profil dans la couche sous-jacente (910).

13. Procédé selon la revendication précédente comprenant une étape de remplissage du profil obtenu par un métal et /ou dans lequel le profil obtenu en fin de procédé est une structure double damascène.

14. Procédé selon l'une quelconque des revendications précédentes dans lequel la couche à graver (410) est une couche ou un substrat dont le matériau est pris parmi : le silicium, le silicium germanium, le germanium, le nitrure de silicium, le saphir, le quartz.

15. Procédé selon l'une quelconque des revendications 1 à 12 dans lequel la couche à graver (410) est une couche ou un substrat en SiOCH et dans lequel la couche à graver (410) en SiOCH est surmontée d'une couche protectrice située entre la couche de masquage (420) et la couche à graver (410).

## Patentansprüche

1. Verfahren zum Herstellen von Mustern in einer zu ätzenden Schicht (410) ausgehend von einer Stapelung, die zumindest die zu ätzende Schicht (410) und eine Maskierungsschicht (420) enthält, welche die zu ätzende Schicht (410) überragt, wobei die Maskierungsschicht (420) zumindest ein Muster (421) aufweist, wobei das Verfahren **dadurch gekennzeichnet, ist, dass** es zumindest umfasst:
a) einen Schritt des Modifizierens von zumindest einem Bereich (411) der zu ätzenden Schicht (410) durch Ionenimplantation (430) in Höhe des zumindest einen Musters (421) der Maskierungsschicht (420);
b) zumindest eine Abfolge von Schritten, umfassend:
b1) einen Schritt des Erweiterns (440) von dem zumindest einen Muster (421) der Maskierungsschicht (420), wobei die Maskierungsschicht (420) nach dem Schritt des Modifizierens beibehalten wurde, um den Schritt des Erweiterns auszuführen, wobei der Schritt des Erweiterns (440) so erfolgt, dass das zumindest eine Muster (421) entlang einer Ebene erweitert wird, in welcher die zu ätzende Schicht (410) sich im Wesentlichen erstreckt;
b2) einen Schritt des Modifizierens von zumindest einem Bereich (411', 411") der zu ätzenden Schicht (410) durch Ionenimplantation (430) in Höhe des zumindest einen erweiterten Musters (421) der Maskierungsschicht (420), wobei die Implantation über eine Tiefe erfolgt, die geringer ist als die Implantationstiefe bei dem vorhergehenden Schritt des Modifizierens;
c) einen Schritt des Entfernens (461, 462) der modifizierten Bereiche (411, 411', 411"), wobei das Entfernen einen Schritt des Ätzens der modifizierten Bereiche (411, 411', 411") selektiv auf die nicht modifizierten Bereichen (412) der zu ätzenden Schicht (410) umfasst, wobei der Schritt des Ätzens ein Nassätzen ist;
und wobei
- entweder die Maskierungsschicht (420) eine Hartmaske ist,
- oder die Maskierungsschicht (420) Kohlenstoff enthält und die Stapelung eine Pufferschicht (610) enthält, wobei die Pufferschicht zwischen der kohlenstoffhaltigen Maskierungsschicht (420) und der zu ätzenden Schicht (410) angeordnet ist, wobei die Pufferschicht die zu ätzende Schicht (410) bei der Implantation überdeckt.

2. Verfahren nach dem vorangehenden Anspruch, wobei die Maskierungsschicht (420) Kohlenstoff enthält, wobei die Stapelung eine Pufferschicht (610) enthält, die zwischen der kohlenstoffhaltigen Maskierungsschicht (420) und der zu ätzenden Schicht (410) angeordnet ist und die zu ätzende Schicht (410) bei der Implantation überdeckt, und wobei die Maskierungsschicht (420) Kohlenstoff enthält und die Dicke (613) der Pufferschicht (61) nach dem Schritt des Erweiterns und vor der Implantation (430) ausreicht, um eine Sperre zu bilden, den bei der Implantation (430) den von der Maskierungsschicht (420) stammenden Kohlenstoff daran hindert, in die zu ätzende Schicht (410) einzudringen.

3. Verfahren nach einem der beiden vorangehenden Ansprüche, wobei die Maskierungsschicht (420) Kohlenstoff enthält, wobei die Stapelung eine Pufferschicht (610) enthält, die zwischen der Maskierungsschicht (420) und der zu ätzenden Schicht (410) angeordnet ist und die zu ätzende Schicht (410) bei der Implantation überdeckt, und wobei das Material der Maskierungsschicht (420) und das Material der Pufferschicht (610) verschieden sind und wobei der Schritt des Erweiterns (440) des zumindest einen Musters (421) der Maskierungsschicht (420) ein Ätzen der Maskierungsschicht (420) selektiv auf die Pufferschicht (610) umfasst, wobei das Ätzen vorzugsweise ein anisotropes Ätzen ist, bei dem die Hauptrichtung parallel zu einer Ebene verläuft, in welcher sich die zu ätzende Schicht (410) im Wesentlichen erstreckt.

4. Verfahren nach einem der drei vorangehenden Ansprüche, wobei die Maskierungsschicht (420) Kohlenstoff enthält, wobei die Stapelung eine Pufferschicht (610) enthält, die zwischen der Maskierungsschicht (420) und der zu ätzenden Schicht (410) angeordnet ist und die zu ätzende Schicht (410) bei der Implantation überdeckt, und wobei
- die Pufferschicht (610) aus einem Material besteht, ausgewählt aus den nachstehenden Materialien: SixOy, SiOx, SixNy, SiNx, TiN, SiARC,
oder wobei
- die Maskierungsschicht (420) und die Pufferschicht (610) aus Harz bestehen.

5. Verfahren nach einem der Ansprüche 1 bis 2, wobei die Maskierungsschicht (420) Kohlenstoff enthält, wobei die Stapelung eine Pufferschicht (610) enthält, die zwischen der kohlenstoffhaltigen Maskierungsschicht (420) und der zu ätzenden Schicht (410) angeordnet ist und die zu ätzende Schicht (410) bei der Implantation überdeckt,
und wobei die Maskierungsschicht (420) und die Pufferschicht (610) aus Harz bestehen und wobei die Pufferschicht (610) einen Harzrest in einem Hintergrund des Musters (421) der Maskierungsschicht (420) bildet.

6. Verfahren nach Anspruch 1, wobei die Maskierungsschicht (420) eine Schicht ist, die eine Hartmaske bildet, wobei die Maskierungsschicht (420) in direktem Kontakt mit der zu ätzenden Schicht (410) angeordnet ist und wobei der Schritt des Erweiterns (440) des zumindest einen Musters (421) der Maskierungsschicht (420) ein Ätzen der Maskierungsschicht (420) selektiv auf die zu ätzende Schicht (410) umfasst, wobei das Ätzen ein anisotropes Ätzen ist, bei dem die Hauptrichtung vorzugsweise parallel zu einer Ebene verläuft, in welcher sich die zu ätzende Schicht (410) im Wesentlichen erstreckt.

7. Verfahren nach einem der Ansprüche 1 oder 6, wobei die Maskierungsschicht (420) eine Schicht ist, die eine Hartmaske bildet, wobei auf die Maskierungsschicht (420) zumindest eine Schutzschicht aufgebracht wird, wobei das Material der Schutzschicht so gewählt ist, dass ein vertikaler Verbrauch der Hartmaske bei dem Schritt des Erweiterns (440) des in der Hartmaske (421) gebildeten Musters verhindert bzw. verringert wird.

8. Verfahren nach einem der vorangehenden Ansprüche, wobei die Implantation mit einer Implantationseinrichtung erfolgt oder wobei die Implantation (430) in einem Plasmareaktor erfolgt.

9. Verfahren nach einem der vorangehenden Ansprüche, wobei die Schritte b) und c), insbesondere das Erweitern (440) des zumindest einen Musters (421) und die Implantationstiefe, so gewählt sind, dass die modifizierten Bereiche (411, 411', 411") ein Treppenstufenprofil bilden und wobei nach dem Ätzen eines Treppenstufenprofils in der zu ätzenden Schicht (410) eine Glättung (470) des Profils durch Oxidation und Desoxidation des Materials des Substrats erfolgt.

10. Verfahren nach einem der vorangehenden Ansprüche, wobei:
- das Profil die Negativform einer asphärischen Linsenform aufweist,
oder wobei
- das Profil eine Gießform bildet, die dazu ausgelegt ist, in ein bedruckbares Harz einzudringen, um das Profil durch Nanodruck darauf zu übertragen.

11. Verfahren nach einem der Ansprüche 1 bis 8, wobei vor den Schritten a) bis c) die Maskierungsschicht (420) eine Mehrzahl von Mustern enthält, die Öffnungen in der Dicke der Maskierungsschicht (420) bilden, und wobei der Schritt des Erweiterns so erfolgt, dass das Material der Maskierungsschicht (420), das zumindest zwei Muster trennt, abgetragen wird, so dass diese zumindest zwei Muster nach dem Erweitern verbunden werden.

12. Verfahren nach einem der Ansprüche 1 bis 8, wobei vor den Schritten a) bis c) die Maskierungsschicht (420) eine Mehrzahl von Mustern (421) enthält, die dazu bestimmt sind, Durchkontaktierungen zur Zwischenverbindung zu bilden, wobei der Schritt des Erweiterns so erfolgt, dass zumindest bestimme der Durchkontaktierungen verbunden werden (830) und wobei vorzugsweise das in der zu ätzenden Schicht (410) gebildete Profil dann in die zugrundeliegende Schicht (910) übertragen wird, die von der zu ätzenden Schicht (410) überdeckt ist, wobei die zu ätzende Schicht (410) beim Übertragen des Profils in die zugrundeliegende Schicht (910) als Hartmaske dient.

13. Verfahren nach dem vorangehenden Anspruch, umfassend einen Schritt des Auffüllens von dem erhaltenden Profil mit einem Metall und/oder wobei das am Ende des Verfahrens erhaltene Profil eine doppelte Damaszenerstruktur ist.

14. Verfahren nach einem der vorangehenden Ansprüche, wobei die zu ätzende Schicht (410) eine Schicht oder ein Substrat ist, deren bzw. dessen Material ausgewählt ist aus: Silizium, Silizium-Germanium, Germanium, Siliziumnitrid, Saphir, Quarz.

15. Verfahren nach einem der Ansprüche 1 bis 12, wobei die zu ätzende Schicht (410) eine Schicht oder ein Substrat aus SiOCH ist und wobei die zu ätzende Schicht (410) aus SiOCH von einer Schutzschicht überragt wird, die zwischen der Maskierungsschicht (420) und der zu ätzenden Schicht (410) liegt.

## Claims

1. Method for producing patterns in a layer to be etched (410), from a stack comprising at least the layer to be etched (410) and a masking layer (420) surmounting the layer to be etched (410), the masking layer (420) having at least one pattern (421), the method being **characterised in that** it comprises at least:
a) a step of modifying at least one zone (411) of the layer to be etched (410) by implanting ions (430) to the right of said at least one pattern (421) of said masking layer (420);
b) at least one sequence of steps comprising:
b1) a step of enlarging (440) said at least one pattern (421) of said masking layer (420), said masking layer (420) having been conserved after the modification step in order to carry out the enlarging step, the enlarging step (440) being carried out so as to enlarge said at least one pattern (421) along a plane wherein extends mainly the layer to be etched (410);
b2) a step of modifying at least one zone (411', 411") of the layer to be etched (410) by implanting ions (430) to the right of the at least one enlarged pattern (421) of said masking layer (420), the implantation being carried out over a depth less than the implantation depth of the preceding modification step;
c) a step of removing (461, 462) modified zones (411, 411', 411"), the removal comprising a step of etching modified zones (411, 411', 411") selectively at the non-modified zones (412) of the layer to be etched (410), said etching step being a wet etching;
and wherein:
- either the masking layer (420) is a hard mask,
- or the masking layer (420) comprises carbon and the stack comprises a buffer layer (610), the buffer layer being arranged between the masking layer (420) comprising carbon and the layer to be etched (410), the buffer layer covering the layer to be etched (410) during the implantation.

2. Method according to the preceding claim, wherein the masking layer (420) comprises carbon, the stack comprising a buffer layer (610) which is arranged between the masking layer (420) comprising carbon and the layer to be etched (410) and which covers the layer to be etched (410) during the implantation and wherein the masking layer (420) comprises carbon and wherein the thickness (613) of the buffer layer (61), after the enlarging step and before the implantation (430), is sufficient to form a barrier preventing, during said implantation (430), the carbon coming from the masking layer (420) from entering inside the layer to be etched (410).

3. Method according to any one of the two preceding claims, wherein the masking layer (420) comprises carbon, the stack comprising a buffer layer (610) which is arranged between the masking layer (420) and the layer to be etched (410) and which covers the layer to be etched (410) during the implantation and wherein the material of the masking layer (420) and the material of the buffer layer (610) are different, and wherein the step of enlarging (440) the at least one pattern (421) of the masking layer (420) comprises an etching of the masking layer (420) selectively at the buffer layer (610), the etching preferably being an anisotropic etching, of which the main direction is parallel to a plane wherein mainly extends the layer to be etched (410).

4. Method according to any one of the three preceding claims, wherein the masking layer (420) comprises carbon, the stack comprising a buffer layer (610) which is arranged between the masking layer (420) and the layer to be etched (410) and which covers the layer to be etched (410) during the implantation and wherein
- the buffer layer (610) is made of a material taken from among the following materials: SixOy, SiOx, SixNy, SiNx, TiN, SiARC,
or wherein
- the masking layer (420) and the buffer layer (610) are made of resin.

5. Method according to any one of claims 1 to 2 wherein the masking layer (420) comprises carbon, the stack comprising a buffer layer (610) which is arranged between the masking layer (420) comprising carbon and the layer to be etched (410) and which covers the layer to be etched (410) during the implantation,
wherein the masking layer (420) and the buffer layer (610) are made of resin, and wherein the buffer layer (610) forms a resin residue in a bottom of the pattern (421) of the masking layer (420).

6. Method according to claim 1, wherein the masking layer (420) is a layer forming a hard mask and wherein the masking layer (420) is arranged directly in contact with the layer to be etched (410) and wherein the step of enlarging (440) the at least one pattern (421) of the masking layer (420) comprises an etching of the masking layer (420) selectively at the layer to be etched (410), the etching being an anisotropic etching, of which the main direction is preferably parallel to a plane wherein mainly extends the layer to be etched (410).

7. Method according to any one of claims 1 or 6, wherein the masking layer (420) is a layer forming a hard mask and wherein, on the masking layer (420), at least one protective layer is arranged, the material of the protective layer being selected so as to prevent or to reduce a vertical consumption of the hard mask during the step of enlarging (440) the pattern (421) formed in the hard mask.

8. Method according to any one of the preceding claims, wherein the implantation is carried out with an implanter or wherein the implantation (430) is carried out in a plasma reactor.

9. Method according to any one of the preceding claims, wherein steps b) and c) are selected, in particular the enlarging (440) of the at least one pattern (421) and the implantation depth, such that the modified zones (411, 411', 411") form a stair profile and wherein after etching in the layer to be etched (410) of a stair profile, a smoothing (470) of said profile is proceeded with, by oxidation and deoxidation of the material of the substrate.

10. Method according to any one of the preceding claims, wherein:
- the profile has the negative of an aspherical lens shape,
or wherein
- the profile forms a mould configured to enter into a printable resin in order to transfer the profile into it by nano-printing.

11. Method according to any one of claims 1 to 8, wherein prior to steps a) to c), the masking layer (420) comprises a plurality of patterns forming openings in the thickness of the masking layer (420) and wherein the enlarging step is carried out so as to remove the material from the masking layer (420) separating at least two patterns, so as to join these at least two patterns after enlarging.

12. Method according to any one of claims 1 to 8, wherein prior to steps a) to c), the masking layer (420) comprises a plurality of patterns (421) intended to form interconnecting vias, wherein the enlarging step is carried out so as to join (830) at least some of the interconnecting vias and preferably wherein the profile formed in the layer to be etched (410) is then transferred into an underlying layer (910) covered by the layer to be etched (410), the layer to be etched (410) acting as a hard mask during the transfer of the profile into the underlying layer (910).

13. Method according to the preceding claim, comprising a step of filling the profile obtained with a metal and/or wherein the profile obtained at the end of the method is a double damascene structure.

14. Method according to any one of the preceding claims, wherein the layer to be etched (410) is a layer or a substrate of which the material is taken from among: silicon, silicon germanium, germanium, silicon nitride, sapphire, quartz.

15. Method according to any one of claims 1 to 12, wherein the layer to be etched (410) is a layer or a substrate made of SiOCH and wherein the layer to be etched (410) made of SiOCH is surmounted on a protective layer located between the masking layer (420) and the layer to be etched (410).
